# EUROPEAN PATENT APPLICATION

(11) **EP 3 761 372 A1**
(43) Date of publication of application: **06.01.2021**
(21) Application number: 19826677.7
(22) Date of filing: 03.02.2019
(51) Int. Cl.: H01L 29/78, H01L 29/08, H01L 29/10, H01L 29/423, H01L 21/336

(54) **SEMICONDUCTOR DEVICE AND TERMINAL DEVICE**

(30) Priority: 28.06.2018 CN 201810689312
(71) Applicant: HUAWEI TECHNOLOGIES CO., LTD., Shenzhen, Guangdong 518129 (CN)
(72) Inventor: WANG, Huaifeng, Shenzhen, Guangdong 518129 (CN)
(74) Representative: Pfenning, Meinig & Partner mbB
(86) International application number: PCT/CN2019/074710
(87) International publication number: WO 2020/001033

(57) **Abstract**

This application discloses a semiconductor device and a manufacturing method. The device uses a groove-gate structure and a double-longitudinal RESURF technology using a longitudinal field plate and a longitudinal P-N structure, and a channel is disposed on a bottom of a groove, so that a drift region size of a cell is reduced, a drift region concentration is increased, a drift region resistance is reduced, and a cell size is reduced. The device may be implemented based on a conventional spit trench gate MOS process or a monolithic integrated BCD process technology. A manufacturing process is simple, and manufacturing costs are low. In this way, in this application, a conventional low-cost manufacturing technology is used to implement a bidirectional-voltage-withstand MOS-type switch device that has a low on resistance and high reliability. In addition, this application further discloses a terminal device.

## Description

This application claims priority to Chinese Patent Application No. 201810689312.6, filed with China National Intellectual Property Administration on June 28, 2018 and entitled "POWER SEMICONDUCTOR DEVICE AND MANUFACTURING METHOD", which is incorporated herein by reference in its entirety.

### TECHNICAL FIELD

This application relates to a semiconductor device and the field of semiconductor process technologies, and in particular, to a power semiconductor device and a manufacturing method.

### BACKGROUND

A power semiconductor device is mainly a power metal oxide semiconductor field effect transistor (power MOSFET, usually power MOS for short), an insulated gate bipolar transistor (IGBT), or a power integrated circuit (power IC, usually PIC for short). These devices or an integrated circuit can work at a very high frequency. When working at the high frequency, the circuit consumes less power and requires fewer materials, thereby greatly reducing a size and weight of the device. In particular, a power system on a chip (power system on a chip, PSOC for short) with a high integration level can integrate a sensor device and a circuit, a signal processing circuit, an interface circuit, a power device, a circuit, and the like onto a silicon chip, so that the silicon chip has a function of precisely adjusting output based on a load requirement and has a function of self-protection based on overheat, overvoltage, and overcurrent.

The technical field of the power semiconductor device is always committed to reducing an on resistance per unit area of the power semiconductor device, reducing a chip area, and reducing a power loss of the device while a specific withstand voltage is satisfied.

### SUMMARY

In view of this, this application provides a semiconductor device and a manufacturing method of the semiconductor device, so as to reduce an on resistance per unit area of the semiconductor device, reduce a chip area, and reduce a power loss of the device.

Optionally, the semiconductor device is a power semiconductor device. It should be known that a specific product form of the semiconductor device may also be another form different from the power semiconductor device. This is not limited herein.

To achieve the foregoing objective, this application uses the following technical solutions.

According to a first aspect of this application, a power semiconductor device is provided, including:
a substrate;
an epitaxial layer located on one side of the substrate;
a groove located in the epitaxial layer, where a gate electrode is disposed in the groove, and there is an oxidized layer between an inner wall of the groove and an outer wall of the gate electrode;
drift regions located on two sides of the groove;
a first drain electrode and a second drain electrode that are respectively located in the drift regions on the two sides of the groove; and
a channel, where the channel is located between a bottom wall of the groove and the substrate, and is close to a groove bottom of the groove;
a doping type of the substrate, the epitaxial layer, and the channel is a first type, and a doping type of the drift region, the first drain electrode, and the second drain electrode is a second type; and
in the first type and the second type, one is a P type and the other is an N type.

Optionally, the semiconductor device includes a plurality of cells connected in parallel. For a structure of each cell, refer to the foregoing limitation. In other words, the cell may include the substrate, the epitaxial layer, and the groove, the channel, and the drift regions that are located in the epitaxial layer, and further include a first drain electrode and a second drain electrode that are located in the drift regions. In other words, the foregoing embodiment defines a structure of one cell located in the semiconductor device.

The power semiconductor device provided in the first aspect of this application is a lateral MOS-type device, and the power semiconductor device is of an MOS structure without a source electrode. Removal of an area of the source electrode helps reduce a cell size, and reducing of the cell size helps reduce an on resistance per unit area of the power semiconductor device.

In addition, the power semiconductor device is of a single channel structure, and disposing of the single channel helps reduce a channel resistance and an on resistance of the cell.

In addition, in the power semiconductor device, a field oxidized layer is disposed inside the epitaxial layer (device body) to form an internal longitudinal field plate (longitudinal field oxidized layer). The drift regions and the epitaxial layer in the power semiconductor device form an internal longitudinal PN junction (internal longitudinal diode). Therefore, a double-RESURF (Reduced Surface Field, reduced surface field) technology using the internal longitudinal field plate and the internal longitudinal P/N junction is used in this application, greatly reducing a chip area.

In addition, compared with a conventional LDMOS (Laterally Diffused Metal Oxide Semiconductor, laterally diffused metal oxide semiconductor) technology, an internal longitudinal diode of the device is formed, so that the device does not have a strong electric field on a surface, and does not need a surface field plate technology. This helps reduce a transverse size of the drift region, and further reduce the cell size. In addition, the device uses a longitudinal gate electrode field oxidized layer on which a charge balance mechanism is used. This helps increase a concentration of the drift region, thereby reducing the resistance of the drift region, and further reducing the on resistance of the cell.

In conclusion, the power semiconductor device provided in the first aspect of this application can reduce the on resistance per unit area of the power semiconductor device, reduce the chip area, and reduce the power loss of the device.

Optionally, there is a first oxidized layer between an inner side wall of the groove and an outer side wall of the gate electrode, and there is a second oxidized layer between the groove bottom of the groove and a bottom of the gate electrode. It should be explained that the bottom of the gate electrode faces the groove bottom of the groove. Specifically, the first oxidized layer is a field oxidized layer, a gate oxidized layer, or includes both a field oxidized layer and a gate oxidized layer. Further, the second oxidized layer is a gate oxidized layer.

With reference to the first aspect of this application, in a first possible implementation, along a thickness direction of the epitaxial layer (or along a depth direction of the groove), the groove includes a main part and a protruding part that extends from the main part and protrudes towards the substrate.

Based on the foregoing first possible implementation, an on resistance of a cell can be reduced based on a premise that voltage withstand blocking is ensured.

With reference to the first possible implementation of the first aspect of this application, in a second possible implementation, the field oxidized layer includes a first field oxidized layer located on a side wall of the main part and a second field oxidized layer located on a side wall of the protruding part. A thickness of the first field oxidized layer is greater than a thickness of the second field oxidized layer.

Based on the foregoing second possible implementation, an on resistance of a cell can be reduced based on a premise that voltage withstand blocking is ensured.

With reference to the second possible implementation of the first aspect of this application, in a third possible implementation, a thickness of the first field oxidized layer is between 350 Å and 1000 Å.

Based on the foregoing third possible implementation, voltage withstand performance of the device can be ensured.

With reference to any one of the first to the third possible implementations of the first aspect of this application, in a fourth possible implementation, along the thickness direction of the epitaxial layer, the gate electrode includes a first part and a second part that extends from the first part to the bottom wall of the groove, and a width of the first part is greater than a width of the second part.

Based on the foregoing fourth possible implementation, performance of the semiconductor device can be improved.

With reference to the first aspect or any one of the foregoing possible implementations of this application, in a fifth possible implementation, the device further includes a body electrode, the body electrode is located in the epitaxial layer and is close to an outer surface of the epitaxial layer, and at least one cell is located in an area enclosed by the body electrode.

Based on the foregoing fifth possible implementation, a cell density of the power semiconductor device can be increased, thereby increasing power of the power semiconductor device.

With reference to the first aspect or any one of the first to the fourth possible implementations of this application, in a sixth possible implementation, the device further includes a body electrode and a well region of an isolated island shape located in the groove, and the body electrode is located in the well region and close to an outer surface of the well region; and a doping type of the well region is the first type.

With reference to the first aspect or any one of the foregoing possible implementations of this application, in a seventh possible implementation, electrodes of the gate electrode, the first drain electrode, and the second drain electrode are all led out to an outer surface of the device.

Based on the foregoing seventh possible implementation, miniaturization of the semiconductor device can be facilitated.

With reference to the first aspect or any one of the foregoing possible implementations of this application, in an eighth possible implementation, the first drain electrode and the second drain electrode are symmetrically distributed on the two sides of the groove.

Based on the foregoing eighth possible implementation, bidirectional voltage withstand performance of the semiconductor device can be improved.

With reference to the sixth possible implementation of the first aspect of this application, in a ninth possible implementation, there is a field oxidized layer on a side wall of the well region.

Based on the foregoing ninth possible implementation, voltage withstand performance of the semiconductor device can be improved.

With reference to the first aspect or any one of the foregoing possible implementations of this application, in a tenth possible implementation, the gate electrode is a polycrystalline silicon gate electrode.

Based on the foregoing eighth possible implementation, performance of the semiconductor device can be improved and manufacturing costs can be reduced.

According to a second aspect of this application, a terminal device is provided. The terminal device includes a power semiconductor device and a controller, where the power semiconductor device is the power semiconductor device according to any one of the foregoing possible implementations, and the controller is configured to control on and/or off of the power semiconductor device.

The terminal device provided in the second aspect of this application has the corresponding effects described in the foregoing power semiconductor device.

According to a third aspect of this application, a manufacturing method of a power semiconductor device is provided, including:
forming an epitaxial layer on one side of a substrate;
forming a groove in the epitaxial layer, where a gate electrode is disposed in the groove, a side wall of the groove is covered with a field oxidized layer, a specific area of a bottom wall of the groove is covered with a gate oxidized layer, and the specific area is an area covered by a front projection of a bottom of the gate electrode on the bottom wall of the groove;
forming drift regions on two sides of the groove, and forming a first drain electrode and a second drain electrode respectively in the drift regions on the two sides of the groove;
forming a channel between the bottom wall of the groove and the substrate and that is close to an area of the bottom wall of the groove;
a doping type of the substrate, the epitaxial layer, and the channel is a first type, and a doping type of the drift region, the first drain electrode, and the second drain electrode is a second type; and
in the first type and the second type, one is a P type and the other is an N type.

Based on the manufacturing method provided in the foregoing third aspect, the manufacturing method may be implemented based on a conventional split trench gate MOS process or a monolithic integrated BCD process technology. A manufacturing process is simple, and manufacturing costs are low.

With reference to the third aspect of this application, in a first possible implementation, the forming a groove in the epitaxial layer specifically includes:
forming a first well region in the epitaxial layer, where a doping type of the first well region is the second type;
etching the first well region to form a main part of the groove;
etching towards the substrate from a bottom of the main part to form a protruding part of the groove, where the main part and the protruding part form the groove; and
correspondingly, the forming drift regions on two sides of the groove specifically includes:
   using the first well region located outside the main part and the protruding part as the drift regions.

Based on the foregoing first possible implementation, a manufacturing process can be simplified, and manufacturing costs can be reduced.

With reference to the first possible implementation of the third aspect of this application, in a second possible implementation, the forming a channel between the bottom wall of the groove and the substrate and that is close to an area the bottom wall of the groove specifically includes:
injecting doping ions to the bottom wall of the protruding part, to form the channel between the bottom wall of the protruding part and the substrate and that is close to an area the bottom wall of the protruding part of the groove, where a conductivity type of the doping ions is the first type.

Based on the foregoing second possible implementation, a manufacturing process can be simplified, and manufacturing costs can be reduced.

With reference to the first possible implementation of the third aspect of this application, in a third possible implementation, after the etching the first well region to form a main part of the groove, and before the etching towards the substrate from a bottom of the main part to form a protruding part of the groove, the method further includes:
forming a first field oxidized layer on a side wall of the main part; and
the etching towards the substrate from a bottom of the main part to form a protruding part of the groove is specifically:
   etching towards the substrate from a bottom of the main part whose side wall is covered with the first field oxidized layer, to form the protruding part of the groove.

Based on the foregoing third possible implementation, a manufacturing process can be simplified, and manufacturing costs can be reduced.

With reference to the third possible implementation of the third aspect of this application, in a fourth possible implementation, after the etching towards the substrate from the bottom of the main part whose side wall is covered with the first field oxidized layer, to form the protruding part of the groove, the method further includes:
forming a second field oxidized layer on a side wall of the protruding part, and forming a gate oxidized layer on a bottom wall of the protruding part.

Based on the foregoing fourth possible implementation, a manufacturing process can be simplified, and manufacturing costs can be reduced.

With reference to the third possible implementation of the third aspect of this application, in a fifth possible implementation, the forming a first field oxidized layer on a side wall of the main part specifically includes:
filling up silicon dioxide into the main part; and
etching silicon dioxide in a middle area of the main part to form the first field oxidized layer on the side wall of the main part of the groove.

Based on the foregoing fifth possible implementation, a manufacturing process can be simplified, and manufacturing costs can be reduced.

With reference to the third aspect or any one of the foregoing possible implementations of this application, in a sixth possible implementation, the method further includes:
forming a body electrode in the epitaxial layer and on an outer surface close to the epitaxial layer, and at least one cell is located in an area enclosed by the body electrode.

Based on the foregoing sixth possible implementation, a manufacturing process can be simplified, and manufacturing costs can be reduced.

With reference to the third aspect of this application, in a seventh possible implementation, the forming a groove in the epitaxial layer specifically includes:
forming a second well region and a third well region respectively in a first region and a second region of the epitaxial layer, where the second area of the epitaxial layer is located on two sides of the first area of the epitaxial layer, the second well region includes a first part and a second part that extends from the first part to a bottom of the second well region, the second well region includes the first region and the second region surrounding the first region, a doping type of the second well region is the first type, and a doping type of the third well region is the second type; and
etching the first part of the second region of the second well region and a preset range of the third well region on a side margin of the first part to form the groove;
correspondingly, the forming drift regions on two sides of the groove specifically includes:
   using the third well region located outside the groove as the drift regions; and
   correspondingly, the forming a channel between the bottom wall of the groove and the substrate and that is close to an area the bottom wall of the groove specifically includes:
      forming the second part of the second well region as the channel.

Based on the foregoing seventh possible implementation, a manufacturing process can be simplified, and manufacturing costs can be reduced.

With reference to the seventh possible implementation of the third aspect of this application, in an eighth possible implementation, after the forming a groove in the epitaxial layer, the method further includes:
forming a field oxidized layer on a side wall of the groove.

Based on the foregoing eighth possible implementation, a manufacturing process can be simplified, and manufacturing costs can be reduced.

With reference to the eighth possible implementation of the third aspect of this application, in a ninth possible implementation, after the forming a field oxidized layer on a side wall of the groove, the method further includes:
forming a gate oxidized layer in a specific area of the bottom wall of the groove, and the specific area of the bottom wall of the groove is an area covered by a front projection of a bottom wall of a to-be-formed gate electrode on the bottom wall of the groove.

Based on the foregoing ninth possible implementation, a manufacturing process can be simplified, and manufacturing costs can be reduced.

With reference to the ninth possible implementation of the third aspect of this application, in a tenth possible implementation, after the forming a gate oxidized layer in a specific area of the bottom wall of the groove, the method further includes:
filling a gate electrode material into the groove to form the gate electrode.

Based on the foregoing tenth possible implementation, a manufacturing process can be simplified, and manufacturing costs can be reduced.

With reference to the seventh possible implementation of the third aspect of this application, in an eleventh possible implementation, the etching the first part of the second region of the second well region and a preset range of the third well region on a side margin of the first part to form the groove specifically includes:
etching a first sub-part of the first part of the second region of the second well region and a preset range of the third well region on a side margin of the first sub-part, to form the main part of the groove; and the first part of the second well region includes the first sub-part and a second sub-part that extends from the first sub-part to the bottom of the second well region;
etching the second sub-part of the first part of the second region of the second well region towards the substrate from a bottom of the main part to form a protruding part of the groove, where the main part and the protruding part form the groove; and
correspondingly, the using the third well region located outside the groove as the drift regions is specifically:
   using the third well region located outside the main part and the protruding part as the drift regions.

Based on the foregoing eleventh possible implementation, a manufacturing process can be simplified, and manufacturing costs can be reduced.

With reference to the eleventh possible implementation of the third aspect of this application, in a twelfth possible implementation, after the forming a main part of the groove, and before the forming a protruding part of the groove, the method further includes:
forming a first field oxidized layer on a side wall of the main part; and
the etching the second sub-part of the first part of the second region of the second well region towards the substrate from a bottom of the main part to form a protruding part of the groove specifically includes:
   etching the second sub-part of the first part of the second region of the second well region towards the substrate from a bottom of the main part whose side wall is covered with the first field oxidized layer, to form the protruding part of the groove.

Based on the foregoing twelfth possible implementation, a manufacturing process can be simplified, and manufacturing costs can be reduced.

With reference to the twelfth possible implementation of the third aspect of this application, in a thirteenth possible implementation, after the forming a protruding part of the groove, the method further includes:
forming a second field oxidized layer on a side wall of the protruding part, and forming a gate oxidized layer in a specific area of a bottom wall of the groove, and the specific area is an area covered by a front projection of a bottom of the gate electrode on the bottom wall of the groove.

Based on the foregoing thirteenth possible implementation, a manufacturing process can be simplified, and manufacturing costs can be reduced.

With reference to the twelfth possible implementation of the third aspect of this application, in a fourteenth possible implementation, the forming a first field oxidized layer on a side wall of the main part specifically includes:
filling up silicon dioxide into the main part; and
etching silicon dioxide in a middle area of the main part to form the first field oxidized layer on the side wall of the main part of the groove.

Based on the foregoing fourteenth possible implementation, a manufacturing process can be simplified, and manufacturing costs can be reduced.

With reference to any one of the eleventh possible implementation to the fourteenth possible implementation of the third aspect of this application, in a fifteenth possible implementation, the method further includes:
forming a body electrode inside the first area of the second well region, where the body electrode is close to an outer surface of the second well region.

Based on the foregoing tenth possible implementation, a manufacturing process can be simplified, manufacturing costs can be reduced, and current equalization of the cell can be improved.

Compared with the prior art, this application has the following beneficial effects:
It can be learnt from the foregoing technical solution that the power semiconductor device provided in this application is a lateral MOS-type device, and the power semiconductor device is of an MOS structure without a source electrode. Removal of an area of the source electrode helps reduce a cell size, and reducing of the cell size helps reduce an on resistance per unit area of the power semiconductor device.

In addition, the power semiconductor device is of a single channel structure, and disposing of the single channel helps reduce a channel resistance and an on resistance of the cell.

In addition, in the power semiconductor device, a field oxidized layer is disposed inside the epitaxial layer (device body) to form an internal longitudinal field plate (longitudinal field oxidized layer). The drift regions and the epitaxial layer in the power semiconductor device form an internal longitudinal PN junction (internal longitudinal diode). Therefore, a double-RESURF (Reduced Surface Field, reduced surface field) technology using the internal longitudinal field plate and the internal longitudinal P/N junction is used in this application, greatly reducing a chip area.

In addition, compared with a conventional LDMOS (Laterally Diffused Metal Oxide Semiconductor, laterally diffused metal oxide semiconductor) technology, an internal longitudinal diode of the device is formed, so that the device does not have a strong electric field on a surface, and does not need a surface field plate technology. This helps reduce a transverse size of the drift region, and further reduce the cell size. In addition, the device uses a longitudinal gate electrode field oxidized layer on which a charge balance mechanism is used. This helps increase a concentration of the drift region, thereby reducing the resistance of the drift region, and further reducing the on resistance of the cell.

In conclusion, the power semiconductor device provided in this application can reduce the on resistance per unit area of the power semiconductor device, reduce the chip area, and reduce the power loss of the device.

### BRIEF DESCRIPTION OF DRAWINGS

FIG. 1 is a schematic cross-sectional structural diagram of a power semiconductor device commonly used in the technical field;
FIG. 2 is a schematic diagram of a device symbol of a power semiconductor device commonly used in the industry;
FIG. 3A and FIG. 3B are schematic diagrams of a cross-sectional structure and a device symbol of a power semiconductor device in the prior art;
FIG. 4 is a top view of a power semiconductor device according to Embodiment 1 of this application;
FIG. 5 is a schematic cross-sectional structural diagram of a power semiconductor device according to Embodiment 1 of this application;
FIG. 6 is a schematic diagram of a device symbol of a cell of a power semiconductor device according to Embodiment 1 of this application;
FIG. 7 is a schematic front view of a device product according to Embodiment 1 of this application;
FIG. 8 is a schematic three-dimensional diagram of a final device product formed by performing wafer level chip packaging according to an embodiment of this application;
FIG. 9 is a schematic diagram of a structural parameter of a device cell used in a simulation experiment according to Embodiment 1 of this application;
FIG. 10A and FIG. 10B are simulation curve diagrams of a breakdown voltage of a power semiconductor device according to Embodiment 1 of this application, where FIG. 10A is a simulation curve diagram of a forward breakdown voltage, and FIG. 10B is a simulation curve diagram of a reverse breakdown voltage;
FIG. 11 is a simulation curve diagram of a threshold voltage of a power semiconductor device according to Embodiment 1 of this application;
FIG. 12 is a simulation result diagram of an on resistance of a power semiconductor device according to this embodiment of this application;
FIG. 13 is a schematic flowchart of a manufacturing method of a power semiconductor device according to Embodiment 1 of this application;
FIG. 14A to FIG. 14I are schematic cross-sectional structural diagrams corresponding to a series of manufacturing procedures of a manufacturing method of a power semiconductor device according to Embodiment 1 of this application;
FIG. 15 is a schematic top view of a power semiconductor device according to Embodiment 2 of this application;
FIG. 16 is a schematic cross-sectional structural diagram of a power semiconductor device along a direction of I-I in FIG. 15 according to Embodiment 2 of this application;
FIG. 17 is a schematic cross-sectional structural diagram of a power semiconductor device along a direction of II-II in FIG. 15 according to Embodiment 2 of this application;
FIG. 18 is a schematic top view of another power semiconductor device according to Embodiment 2 of this application;
FIG. 19 is a schematic cross-sectional structural diagram of another power semiconductor device along a direction of I-I in FIG. 18 according to Embodiment 2 of this application;
FIG. 20 is a schematic cross-sectional structural diagram of another power semiconductor device along a direction of II-II in FIG. 18 according to Embodiment 2 of this application;
FIG. 21 is a schematic diagram of a structural parameter of a device cell used in a simulation experiment according to Embodiment 2 of this application;
FIG. 22A and FIG. 22B are simulation curve diagrams of a breakdown voltage of a power semiconductor device according to Embodiment 2 of this application, where FIG. 22A is a simulation curve diagram of a forward breakdown voltage, and FIG. 22B is a simulation curve diagram of a reverse breakdown voltage;
FIG. 23 is a simulation curve diagram of a threshold voltage of a power semiconductor device according to Embodiment 2 of this application;
FIG. 24 is a simulation result diagram of an on resistance of a power semiconductor device according to Embodiment 2 of this application;
FIG. 25 is a schematic flowchart of a manufacturing method of a power semiconductor device according to Embodiment 2 of this application;
FIG. 26A to FIG. 26I are schematic structural diagrams corresponding to a series of manufacturing procedures of a manufacturing method of a power semiconductor device according to Embodiment 2 of this application;
FIG. 27 is a schematic flowchart of a manufacturing method of another power semiconductor device according to Embodiment 2 of this application;
FIG. 28A to FIG. 28F are schematic cross-sectional structural diagrams corresponding to a series of manufacturing procedures of a manufacturing method of a power semiconductor device according to Embodiment 2 of this application;
FIG. 29A is a schematic diagram of a groove similar to a rectangular according to this application;
FIG. 29B is a schematic diagram of a groove similar to a convex shape according to this application;
FIG. 30A is a schematic diagram of a gate electrode according to this application;
FIG. 30B is a schematic diagram of another gate electrode according to this application;
FIG. 31A is a schematic diagram of a groove, similar to a rectangular, in which there is one gate electrode according to this application;

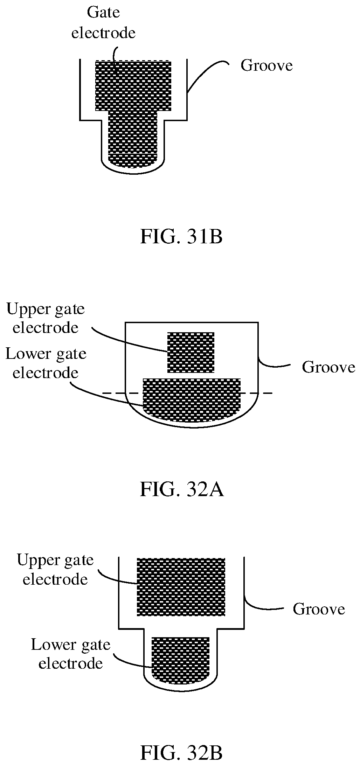

FIG. 31B is a schematic diagram of a groove, similar to a convex shape, in which there is one gate electrode according to this application;
FIG. 32A is a schematic diagram of a groove, similar to a rectangular, in which there are two gate electrodes according to this application;
FIG. 32B is a schematic diagram of a groove, similar to a convex shape, in which there are two gate electrodes according to this application;
FIG. 33 is a schematic front view of a device product according to this application; and
FIG. 34 is a schematic diagram of a terminal device according to this application.

### DESCRIPTION OF EMBODIMENTS

Before specific implementations of this application are described, acronyms and abbreviations, English versions, and definitions of key terms used in the specific implementations of this application are first described.

**Table 1: Acronyms and Abbreviations**

| English acronym/abbreviation | Full English expression/Standard English term |
|---|---|
| MOS | Metal Oxide Semiconductor |
| BCD | Bipolar CMOS DMOS |
| LDMOS | Laterally Diffused Metal Oxide Semiconductor |
| RESURF | Reduced Surface Field |
| USB | Universal Serial Bus |
| OVP | Over Voltage Protection |
| WLCSP | Wafer Level Chip Scale Packaging |

### DEFINITIONS OF KEY TERMS

Channel: A channel is a thin semiconductor layer between a source region and a drain region that are of a field effect transistor.
Cell: A cell is a minimum unit of a power semiconductor device, where the power semiconductor device includes a plurality of cells connected in parallel.
N-type well region: An N-type well region is a low concentration N-type doping region.
Drift region: A drift region is a high resistance region with very few current carriers in a PN junction under influences of drift motion and diffusion.
Epitaxial layer: An epitaxial layer is a semiconductor layer that grows and deposits on a substrate.
Field plate: A field plate is one of common methods of a semiconductor terminal technology. The field plate can increase a curvature radius of a curved surface junction by changing potential distribution on the surface, to suppress surface electric field concentration.
Depletion layer: A depletion layer is an area, near a PN junction, in which current carriers at the depletion layer are depleted by diffusion, leaving only positive and negative ions that cannot move. The depletion layer is also called a space charge region.
RESURF technology: A RESURF technology is a reduced surface field (Reduced Surface Field) technology, and is a technology widely used in designing a device with a transverse high voltage and a low on resistance.

With the development of handheld electronic devices, due to a limitation of space of the device, requirements on electronic components in aspects such as a high density, high integration, miniaturization, high performance, and a low cost are put forward. Power semiconductor devices used by the electronic devices are classified into two types: a discrete solution component and an integrated solution component. The discrete solution component has disadvantages of low integration, a high chip height, and a high cost. The discrete solution component has disadvantages of a serious loss caused by an excessively large on resistance, or an unacceptable cost caused by a large chip area.

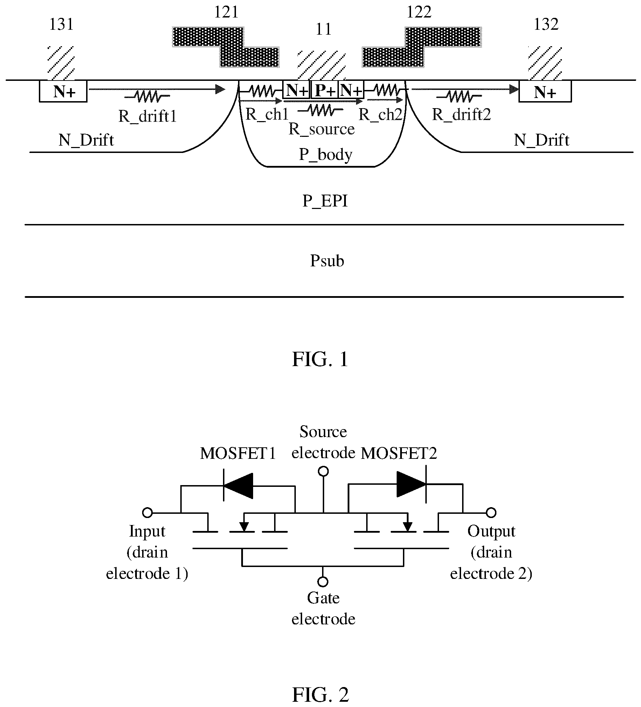

A common structure of a power semiconductor device in the industry is that two MOS devices of a same structure are connected in series. FIG. 1 and FIG. 2 are respectively a cross-sectional structural diagram and a symbol diagram of a device cell corresponding to the structure.

Source electrodes 11 of the two MOS devices are short-circuited together, and a gate electrode 121 and a gate electrode 122 are short-circuited. Two drain electrodes 131 and 132 are respectively used as an input end and an output end of the device. A control signal controls, by using the gate electrode 121 and the gate electrode 122, channels of the two MOS devices to be turned on or turned off at the same time. When the channel is turned off, the drain electrodes 131 and 132 of the two MOSs implement a bidirectional blocking withstand voltage (the bidirectional blocking withstand voltage means that no matter which one of the two drain electrodes 131 and 132 is connected to a positive electrode of a power supply or which one is connected to a negative electrode of a power supply, the blocking withstand voltage can be implemented). When the channel is turned on, a current flows from the drain electrode 131 of one MOS to the drain electrode 132 of the other MOS, and a current path is shown by an arrow in FIG. 1. A total on resistance of the device is twice that of a single MOS device (an on resistance of the single MOS device is a sum of an on resistance R_{drift} of the drift region, a channel resistance R_{ch}, and a source electrode resistance R_{source}). Obvious disadvantages of this power semiconductor device are as follows: 1. In a turned-on condition, a current flows through two MOS channels in a circuit, and a channel resistance is large. 2. An area of a source electrode area of the device not only increases an on resistance of the device, but also causes a chip area waste. 3. In a surface field plate technology, a transverse width of the drift region is limited by a breakdown voltage, and the drift region occupies a large proportion of the whole cell size.

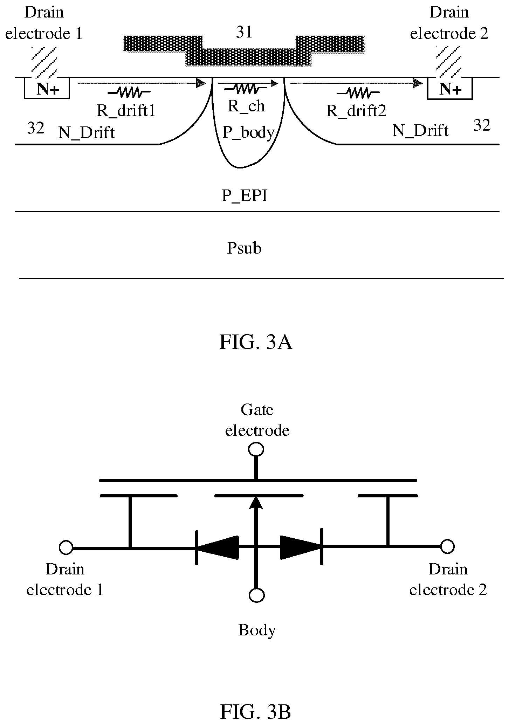

To reduce the on resistance of the device and reduce the chip area, the device structure is optimized on the basis of a common power semiconductor device in the industry. FIG. 3A is a schematic cross-sectional diagram of a cell of the optimized device structure, and FIG. 3B is a schematic cross-sectional diagram of a device symbol of the optimized device structure. In this solution, based on characteristics of a bidirectional-voltage-withstand MOS device, two gate electrodes are combined into a single gate electrode 31 to overcome the common obvious disadvantages of the power semiconductor device in the industry, thereby implementing a single channel, removing a structure of a source area, and reducing an area of a source area. The on resistance of the device is reduced, and the chip area is reduced.

In this solution, a conventional LDMOS structure is used. A disadvantage is that the surface field plate technology must be used to reduce a surface field strength and improve voltage withstand capability of the device. A length of the field plate, a length and a concentration of a drift area 32 determine the voltage withstand capability of the device. To achieve a higher withstand voltage, a relatively long drift region with a low doping concentration must be used. This increases a cell size of the device and increases a resistance of the drift region. It should be known that a relatively high on resistance of the device may cause a relatively low current density. A sum of lengths of bilateral drift regions of the voltage withstand device shown in FIG. 3A accounts for 80% of the cell size, and a resistance of the drift region accounts for about 60% of an on resistance.

To reduce the on resistance per unit area of the power semiconductor device and reduce the chip area, in this application, a groove-gate structure is used, a channel is disposed on a bottom of a groove, and a double-longitudinal RESURF technology using a longitudinal field plate and a longitudinal P-N structure is used, achieving objectives of reducing a drift region size of a cell and increasing a drift region concentration, thereby obtaining an effect of reducing a cell size and reducing a drift region resistance. In other words, in this application, a conventional low-cost manufacturing technology is used to implement a bidirectional-voltage-withstand MOS-type switch device that has a low on resistance and high reliability.

The following describes a specific implementation of the power semiconductor device provided in this embodiment of this application with reference to the accompanying drawings. First, refer to Embodiment 1.

### Embodiment 1

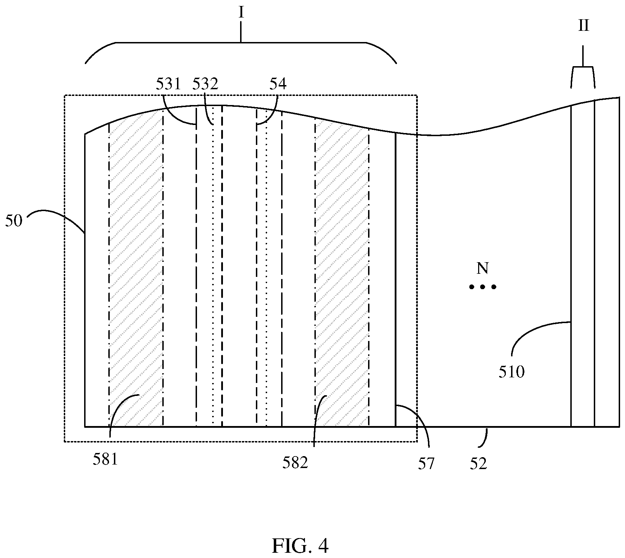

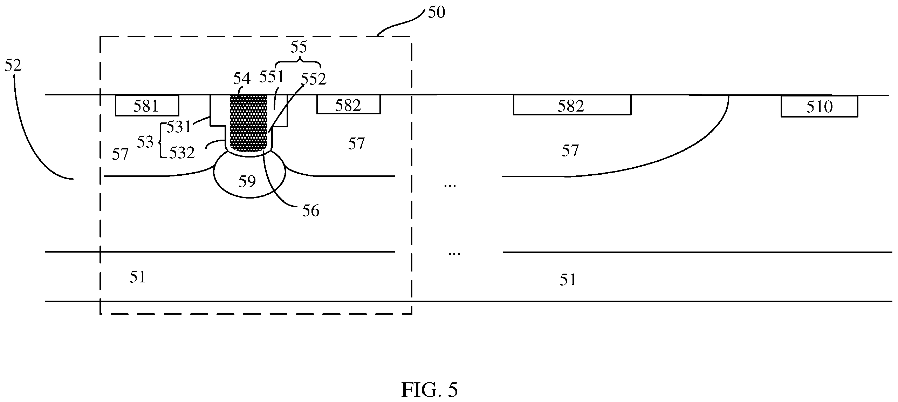

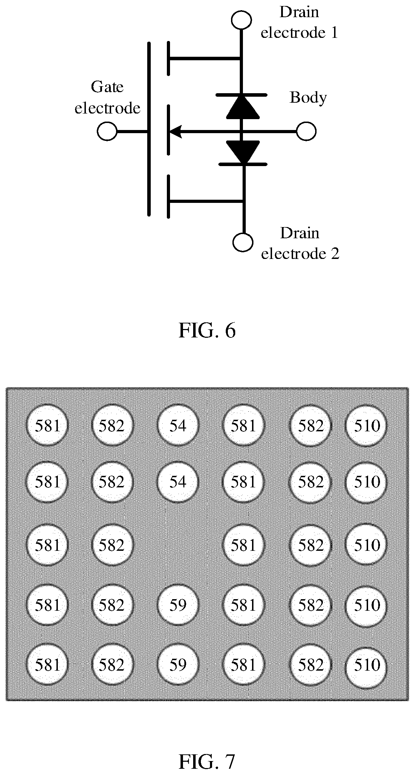

FIG. 4 is a top view of a power semiconductor device according to Embodiment 1 of this application. FIG. 5 is a schematic cross-sectional structural diagram of a power semiconductor device according to Embodiment 1 of this application. FIG. 6 is a schematic diagram of a device symbol of a cell of a power semiconductor device according to Embodiment 1 of this application.

As shown in FIG. 5, the power semiconductor device includes:
a P-type substrate 51;
a P-type epitaxial layer 52 located on one side of the substrate 51;
a groove 53 located in the epitaxial layer 52, where a gate electrode 54 is disposed in the groove 53, a side wall of the groove is covered with a field oxidized layer 55, a specific area of a bottom wall of the groove 53 is covered with a gate oxidized layer 56, and the specific area is an area covered by a front projection of a bottom of the gate electrode 54 on the bottom wall of the groove 53;
N-type drift regions 57 located on two sides of the groove 53, where the field oxidized layer 55 and the drift regions 57 overlap in a transverse direction of a cell;
a first drain electrode 581 and a second drain electrode 582 that are located on the two sides of the groove 53 in the drift regions 57; and
a P-type channel 59, where the P-type channel 59 is located between the bottom wall of the groove 53 and the substrate 51, and is close to an area of the bottom wall of the groove 53.

It should be noted that, in this embodiment of this application, the groove 53 is located in the epitaxial layer 52 and is close to an outer surface area of the epitaxial layer 52, and an opening of the groove 53 faces the outer surface of the epitaxial layer 52.

In an example, a specific structure of the groove 53 may be as follows: along a thickness direction of the epitaxial layer 52, the groove 53 may include a main part 531 and a protruding part 532 that extends from the main part 531 and protrudes towards the substrate 51. It should be understood that a width of the main part 531 is greater than a width of the protruding part 532. The structure of the groove 53 may also be understood in the following manner. The groove is a convex groove, a protruding part of the convex groove protrudes towards the substrate, and an opening of the convex groove faces an upper surface of the epitaxial layer.

When the groove 53 is a convex groove, correspondingly, the field oxidized layer 55 may include a first field oxidized layer 551 along a side wall of the main part 531 and a second field oxidized layer 552 along a side wall of the protruding part 532. In addition, an on resistance of the semiconductor device is reduced while ensuring a voltage withstand value. A thickness of the first field oxidized layer 551 is greater than a thickness of the second field oxidized layer 552.

In addition, when the groove 53 is the convex groove, correspondingly, the N-type drift regions 57 are located outside the main part 531 and the protruding part 532 of the groove.

It should be noted that in this embodiment of this application, the first field oxidized layer 551 may be formed by depositing silicon dioxide by using an oxide deposition process. The second field oxidized layer 552 may be generated in a thermal oxidation manner.

In a specific example, the second field oxidized layer 552 and the gate oxidized layer 56 may be formed at the same time.

To improve voltage withstand performance of the power semiconductor device, a thickness of the first field oxidized layer 551 may be between 350 Å and 1000 Å.

In this embodiment of this application, the P-type channel 59 may be formed, through ion injection, by injecting P-type doping ions to the bottom of the protruding part 532 of the groove 53.

In an example, widths of the gate electrode 54 along a thickness direction of the epitaxial layer may be the same. In another example, widths of the gate electrode along the thickness direction of the epitaxial layer may alternatively be different. In this way, along the thickness direction of the epitaxial layer, the gate electrode 54 may include a first part and a second part that extends from the first part to the bottom wall of the groove 53, and a width of the first part is greater than a width of the second part. In addition, the first part of the gate electrode is located in the main part 531 of the groove, and the second part of the gate electrode is located in the protruding part 532 of the groove.

In another example, the gate electrode 54 may be a polycrystalline silicon gate electrode.

In addition, to implement bidirectional voltage withstand of the power semiconductor device, in an example, the first drain electrode 581 and the second drain electrode 582 are symmetrically distributed on the two sides of the groove 53.

As shown in FIG. 5, a body electrode 510 is located in the epitaxial layer 52 and is close to an outer surface of the epitaxial layer 52. The body electrode 510 may be formed, through ion injection, by injecting P-type doping impurities to the epitaxial layer 52. The body electrode 510 may also be understood as a P-type shallow well formed in the epitaxial layer 52 through ion injection.

As shown in FIG. 4 and FIG. 5, a power semiconductor device provided in Embodiment 1 of this application includes a plurality of cells 50 connected in parallel and the body electrode 510, where the body electrode 510 is located in a surrounding area of the cells 50. In other words, the cells 50 are located in an area enclosed by the body electrode 510. It should be noted that, in this embodiment of this application, one cell 50 may be located in the area enclosed by the body electrode 510, or the plurality of cells 50 may be located in the area enclosed by the body electrode 510. In addition, the cells 50 enclosed by the body electrode 510 share one body electrode. To increase a cell density of the power semiconductor device and further increase power of the power semiconductor device, in an optional embodiment, the body electrode 510 is located in a surrounding area of all the cells 50, in other words, all the cells 50 are surrounded by one body electrode 510, and all the cells 50 share one body electrode 510.

It should be noted that, FIG. 4 shows that the power semiconductor device includes N cells 50 connected in parallel, where N is an integer greater than or equal to 2.

It should be noted that this embodiment of the present invention imposes a limitation on the power semiconductor device. For example, the power semiconductor includes a substrate and an epitaxial layer. The epitaxial layer has a groove, a channel, and a drift region. The drift region has a first drain electrode and a second drain electrode. A gate electrode is disposed in the groove, and there is an oxidized layer between an inner wall of the groove and an outer wall of the gate electrode. This may be understood as a limitation on a structure of a cell located in the power semiconductor device.

It should be understood that in this embodiment a doping type of the substrate, the epitaxial layer, and the channel is a P type, and a doping type of the drift region, the first drain electrode, and the second drain electrode is an N type.

Optionally, a doping type of the substrate, the epitaxial layer, and the channel is an N type, and a doping type of the drift region, the first drain electrode, and the second drain electrode is a P type.

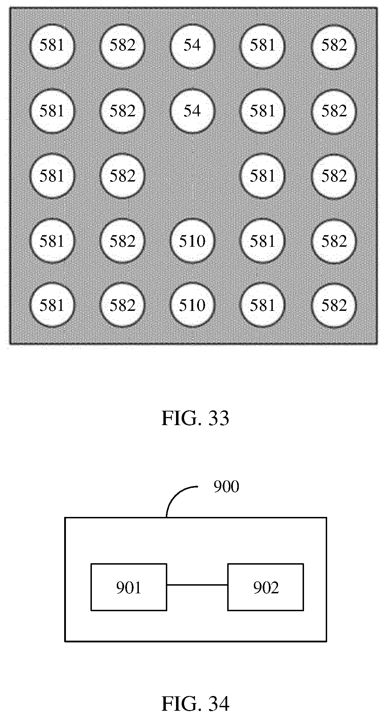

In another example of this application, to implement miniaturization of the device, in a schematic front view of a device product shown in FIG. 7 or FIG. 33, electrodes of the gate electrode 54, the first drain electrode 581, the second drain electrode 582, and the body electrode 510 of the device are all led out to an upper surface of the device, and a signal is transmitted by attaching soldering balls on the surface. Then, wafer level chip packaging (WLCSP) is performed to implement the final device product.

It should be noted that, accompanying drawing signs in FIG. 7 or FIG. 33 are used to represent external pins of corresponding electrodes. For example, accompanying drawing signs 510 are used to represent external pins of the body electrodes 510, and accompanying drawing signs 54 are used to represent external pins of the gate electrodes 54, accompanying drawing signs 581 are used to represent external pins of the first drain electrodes 581, and accompanying drawing signs 582 are used to represent external pins of the second drain electrodes 582.

It should be noted that, as shown in FIG. 7 or FIG. 33, one column of first drain electrodes 581 is followed by one column of second drain electrodes 582, in other words, a column formed by a plurality of first drain electrodes 581 and a column formed by a plurality of second drain electrodes 582 are alternately arranged. Compared with the conventional manner, one or more columns of first drain electrodes 581 are located on one side of the gate electrode 54, and one or more columns of second drain electrodes 582 are located on the other side of the gate electrode 54. In this arrangement manner shown in FIG. 7 or FIG. 33, a distance between a pin of the first drain electrode 581 and a pin of the second drain electrode 582 is reduced, and a parasitic resistance of mental cabling can be reduced.

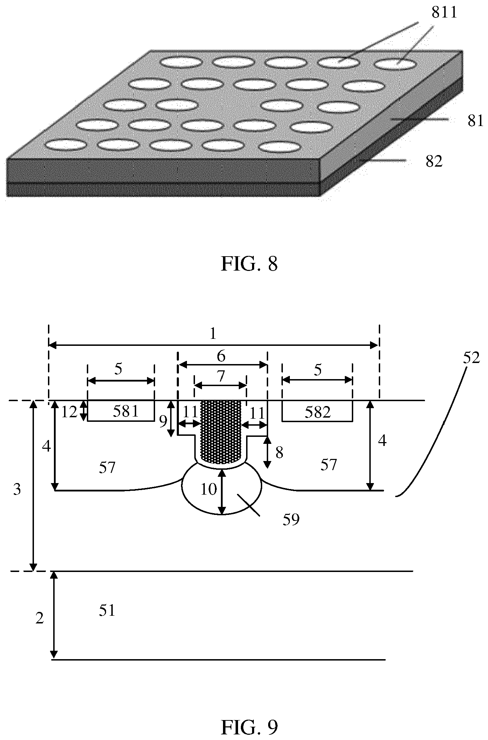

In an example, FIG. 8 is a schematic three-dimensional diagram of the final device product formed by performing wafer level chip packaging according to an embodiment of this application.

As shown in FIG. 8, the packaging structure includes a chip 81 and a back coat 82 located on a back side of the chip 81. A plurality of soldering balls 811 are disposed on a front side of the chip 81, to implement external signal transmission.

A height of a WLCSP device is about 0.5 mm (a thickness of the back coat is about 0.04 mm, a thickness of a silicon chip is about 0.25 mm, and a height of a soldering ball is about 0.2 mm), which is only half of a height of a plastic-packaged device. A heat dissipation effect of the WLCSP device is better than that of a plastic-packaged device of the same size. For example, a thermal resistance Rja of a WLCSP device, including 25 soldering balls, with a chip size of 2 mm x 2 mm is about 30°C/W, which is only half of that of a plastic-packaged device of the same size.

The foregoing is a specific implementation of the power semiconductor device according to Embodiment 1 of this application. In the specific implementation, the power semiconductor device is of an MOS structure without a source electrode. Removal of an area of the source electrode helps reduce a cell size, and reducing of the cell size helps reduce an on resistance per unit area of the power semiconductor device.

In addition, the power semiconductor device is of a single channel (the channel 59 shown in FIG. 5) structure, and disposing of the single channel helps reduce a channel resistance and an on resistance of the cell.

In addition, in the power semiconductor device, a field oxidized layer is disposed inside the epitaxial layer (device body) to form an internal longitudinal field plate (longitudinal field oxidized layer). The drift regions 57 and the epitaxial layer 52 in the power semiconductor device form an internal longitudinal PN junction (internal longitudinal diode). A double-RESURF technology using the internal longitudinal field plate and the internal longitudinal P/N junction is used in this application, greatly reducing a chip area.

It should be noted that, the foregoing longitudinal direction is a thickness direction of the substrate, or a thickness direction of the epitaxial layer, or a depth direction of the groove.

In addition, compared with a conventional LDMOS technology, an internal longitudinal diode of the device is formed, so that the device does not have a strong electric field on a surface, and does not need a surface field plate technology. This helps reduce a transverse size of the drift region, and further reduce the cell size. In addition, the device uses a longitudinal gate electrode field oxidized layer on which a charge balance mechanism is used. This helps increase a concentration of the drift region, thereby reducing the resistance of the drift region, and further reducing the on resistance of the cell.

In conclusion, the power semiconductor device provided in this application can reduce the on resistance per unit area of the power semiconductor device, reduce the chip area, and reduce the power loss of the device.

A cross-section shape of the groove may be a rectangle, may be a convex shape, and naturally may alternatively be another shape. It should be noted that a plane on which the cross-section of the groove is located is perpendicular to a length direction of the groove. To facilitate understanding of the following content, terms that appear in the following are first described herein.

A length direction of the groove is an extension direction of the groove.

A depth direction of the groove is perpendicular to a width direction of the groove. Both the depth of the groove and the width of the groove are concepts based on a cross-section of the groove. It should be noted that both the depth direction of the groove and the width direction of the groove are located in a plane on which the cross-section of the groove is located. Naturally, both the depth direction of the groove and the width direction of the groove are perpendicular to the length direction of the groove.

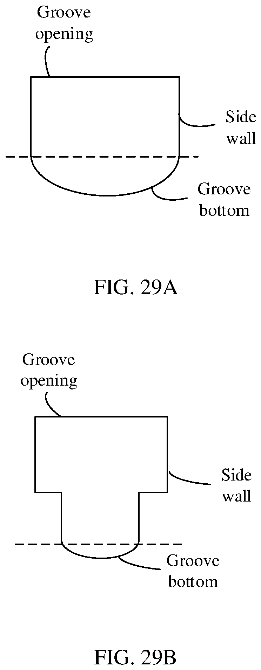

It should be known that the cross-section shape of the groove may be a rectangle, and may alternatively be another shape close to a rectangle (or similar to a rectangle). Commonly, as shown in FIG. 29A, a cross-section shape of the groove is similar to a rectangle. It should be noted that a width of a groove bottom of the groove shrinks (or decreases gradually) along a depth direction of the groove. Optionally, a width of other parts rather than the groove bottom of the groove remains unchanged or approximately unchanged. Referring to the cross-section of the groove shown in FIG. 29A, it may also be considered that the groove bottom is of a shape of a curve close to an arc. It should be noted that, when it is mentioned in the following that the cross-section shape of the groove is a rectangle or is close to a rectangle, reference may be made to the limitation in this paragraph. For brief description, no repeated explanation is provided when it is mentioned in the following that the cross-section shape of the groove is a rectangle or is close to a rectangle (similar to a rectangle).

Optionally, as shown in FIG. 29B, a cross-section of the groove is close to a convex, and is referred to as a convex shape for short. The convex shape includes a main part and a protruding part. It should be explained that a width of the main part is greater than a width of the protruding part. As shown in FIG. 29B, a width of a main part remains unchanged (or approximately unchanged), and a width of a bottom (or referred to as a groove bottom of the groove) of the protruding part shrinks along a depth direction of the groove. Referring to FIG. 29B, it can be easily seen that a width of other parts rather than the bottom of the protruding part remains unchanged or approximately unchanged. It should be noted that, when it is mentioned in the following that the cross-section shape of the groove is a convex shape or is close to a convex shape (similar to a convex shape), reference may be made to the limitation in this paragraph. For brief description, no repeated explanation is provided when it is mentioned in the following that the cross-section shape of the groove is a convex shape or is close to a convex shape (similar to a convex shape).

In an implementation of the present invention, no matter what the cross-section shape of the groove is, there may be only one gate electrode in the groove. There is an oxidized layer between an outer side wall of the gate electrode and an inner side wall of the groove, and between a bottom of the gate electrode and a groove bottom of the groove. Generally, a material of the oxidized layer is silicon dioxide. It should be noted that the bottom of the gate electrode faces the groove bottom of the groove.

Specifically, the oxidized layer between the outer side wall of the gate electrode and the inner side wall of the groove is a first oxidized layer (or in other words, there is a first oxidized layer between the outer side wall of the gate electrode and the inner side wall of the groove). In addition, the oxidized layer between the bottom of the gate electrode and the groove bottom of the groove is a second oxidized layer (or in other words, there is a second oxidized layer between the bottom of the gate electrode and the groove bottom of the groove). It should be noted that the second oxidized layer is a gate oxidized layer.

Optionally, the first oxidized layer is a gate oxidized layer or a field oxidized layer.

Optionally, the first oxidized layer may include both a gate oxidized layer and a field oxidized layer.

It should be noted that if a thickness of the first oxidized layer is equal to or approximately equal to a thickness of the second oxidized layer, the first oxidized layer is a gate oxidized layer. The approximate equality should follow the conventional understanding of persons skilled in the art. If the thickness of the first oxidized layer is obviously greater than the thickness of the second oxidized layer, for example, a difference between the first oxidized layer and the second oxidized layer can be determined by naked eyes, the first oxidized layer is a field oxidized layer.

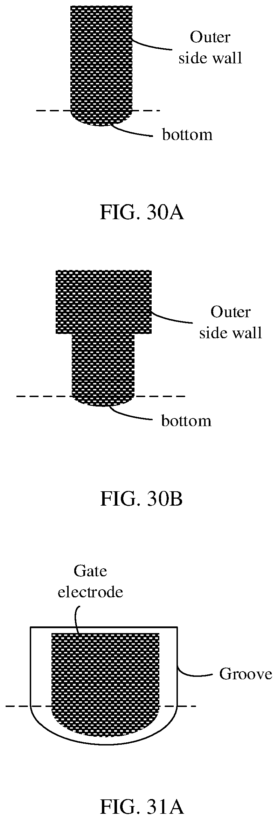

A shape of the bottom of the gate electrode is the same as or approximately the same as a shape of the groove bottom of the groove. When the bottom of the gate electrode is a curved surface, reference may be made to the cross-sectional diagram of the gate electrode shown in FIG. 30A. A width of the bottom of the gate electrode gradually shrinks (or decreases gradually). It should be known that, when the gate electrode is located in the groove, the width of the bottom of the gate electrode gradually shrinks (or decreases gradually) along the depth direction of the groove.

It should be noted that the gate electrode may be completely located in the groove, or may be partially located in the groove (or a part of the gate electrode protrudes out of the groove).

Optionally, if the gate electrode is completely located in the groove, that "there is a first oxidized layer between the outer side wall of the gate electrode and the inner side wall of the groove" means that along a width direction of the groove, there is a first oxidized layer between an area that is on the inner side wall of the groove and that is exactly opposite to the outer side wall of the gate electrode and the outer side wall of the gate electrode.

Optionally, if a part of the gate electrode is located in the groove and the other part of the gate electrode is located outside the groove (it may be understood that the part of the gate electrode protrudes out of the groove), that "there is a first oxidized layer between the outer side wall of the gate electrode and the inner side wall of the groove" means that along a width direction of the groove, there is a first oxidized layer between an area that is on the inner side wall of the groove and that is exactly opposite to an outer side wall of a part, at which the gate electrode is located, of the groove and the outer side wall of the part, at which the gate electrode is located, of the groove.

When only one gate electrode is disposed in the groove, a top surface of the gate electrode may be aligned with a groove opening of the groove or protrude out of the groove opening of the groove, or may be inside the groove.

In a first embodiment of this application, a top surface of the gate electrode is aligned with or protrudes out of the groove opening of the groove. There is a first oxidized layer between an inner side wall of the groove and an outer side wall of the gate electrode. It should be explained that an upper edge of the inner side wall of the groove is a plane on which an outer surface of the epitaxial layer is located, and a lower edge of the inner side wall of the groove is an edge of the bottom of the gate electrode.

Optionally, if a cross-section shape of the groove is close to a rectangle, the first oxidized layer is a gate oxidized layer or a field oxidized layer. In addition, the first oxidized layer may further include both a gate oxidized layer and a field oxidized layer.

It should be noted that, when the first oxidized layer includes both the gate oxidized layer and the field oxidized layer, along a direction from a groove opening of the groove to a groove bottom of the groove, assuming that the groove opening of the groove is located above the groove bottom of the groove (or assuming that the groove bottom of the groove is located below the groove opening of the groove), the field oxidized layer is located above the gate oxidized layer, or in other words, the field oxidized layer is located in an upper part of the inner side wall of the groove, and the gate oxidized layer is located in a lower part of the inner side wall of the groove. It should be noted that, when the "above" or "below" concepts are mentioned in the following, the concepts should also be understood according to the definitions in this paragraph. For brief description, no explanation is provided in the following related part.

Optionally, if a cross-section shape of the groove is close to a convex shape, a part of the first oxidized layer on the main part is a field oxidized layer, and a part of the first oxidized layer on the protruding part is a gate oxidized layer.

In a second embodiment of this application, a top surface of the gate electrode is inside the groove. There is a first oxidized layer between at least partial inner side wall of the groove and an outer side wall of the gate electrode. An upper edge of the at least partial inner side wall is aligned with an edge of a top surface of the gate electrode, and a lower edge of the at least partial inner wall is aligned with an edge of a bottom of the gate electrode. It should be known that the upper edge of the at least partial inner side wall is opposite to the lower edge of the at least partial inner side wall.

Optionally, if a cross-section shape of the groove is close to a rectangle, the first oxidized layer is a gate oxidized layer or a field oxidized layer. In addition, the first oxidized layer may further include both a gate oxidized layer and a field oxidized layer.

It should be noted that, when the first oxidized layer includes both the gate oxidized layer and the field oxidized layer, the field oxidized layer is located in an upper part of the inner side wall of the groove, and the gate oxidized layer is located in a lower part of the inner side wall of the groove.

Optionally, if a cross-section shape of the groove is close to a convex shape, a part of the first oxidized layer on the main part is a field oxidized layer, and a part of the first oxidized layer on the protruding part is a gate oxidized layer.

In this embodiment, along a depth direction of the groove, there is an insulation layer in an area between an extension surface of the top surface of the gate electrode and a plane on which the outer surface of the epitaxial layer is located. It should be explained that the extension surface of the top surface of the gate electrode includes the top surface of the gate electrode and a surface obtained by extending an edge of the gate electrode along the width direction of the groove.

It should be noted that, in this application, the insulation layer may be an oxidized layer. Optionally, the insulation layer is silicon dioxide. For an insulation layer that appears in the following, refer to the explanation herein. Details are not described in the following.

When a plurality of gate electrodes are disposed in the groove, the plurality of gate electrodes are electrically connected, and the plurality of gate electrodes are arranged along a depth direction of the groove. In addition, the plurality of gate electrodes are discontinuous. For brief description, a gate electrode that is farthest from a groove bottom of the groove of the plurality of gate electrodes may be referred to as a top gate electrode. In this case, a top surface of the top gate electrode may be aligned with a groove opening of the groove or protrude out of the groove opening of the groove, or may be inside the groove. Similarly, a gate electrode that is closest to the groove bottom of the groove in the plurality of gate electrodes may be referred to as a bottom gate electrode, and there is a second oxidized layer between a bottom of the bottom gate electrode and the groove bottom of the groove. It can be learned from the foregoing that the second oxidized layer is a gate oxidized layer.

It should be noted that, when a plurality of gate electrodes are disposed in the groove, the "the bottom of the gate electrode" in "between the groove bottom of the groove and the bottom of the gate electrode" mentioned above is specifically the bottom of the bottom gate electrode. Correspondingly, "the bottom of the gate electrode" in "the bottom of the gate electrode faces the bottom of the groove" is also the bottom of the bottom gate electrode.

In a third embodiment of this application, a top surface of the top gate electrode is aligned with or protrudes out of a groove opening of the groove. It should be noted that, in this embodiment, the first oxidized layer between the outer side wall of the bottom gate electrode and the inner side wall of the groove is a gate oxidized layer. It should be known that, assuming that an area exactly opposite to the outer side wall of the bottom gate electrode in the inner side wall of the groove is a bottom area, a first oxidized layer between the outer side wall of the bottom gate electrode and the inner side wall of the groove is a gate oxidized layer. Specifically, a first oxidized layer between an outer side wall of the bottom gate electrode and the bottom area is a gate oxidized layer. Similar descriptions mentioned in another part of this application may also be understood according to the explanation herein. A first oxidized layer between an outer side wall of each of the plurality of gate electrodes rather than the bottom gate electrode and an inner side wall of the groove is a field oxidized layer.

In addition, along a direction from a groove bottom of the groove to a groove opening of the groove, widths of the plurality of gate electrodes are in descending order. A direction of the width of the gate electrode is perpendicular to a depth direction of the groove.

Optionally, in the groove, there is an insulation layer in an area obtained by extending an area between two adjacent gate electrodes (an area between a bottom of an upper gate electrode and a top surface of a lower gate electrode) along a width direction of the groove.

In a fourth embodiment of this application, a top surface of the top gate electrode is inside the groove. In this embodiment, there is an insulation layer in an area between an extension surface of the top surface of the top gate electrode and a plane on which the outer surface of the epitaxial layer is located. It should be explained that the extension surface of the top surface of the top gate electrode includes the top surface of the top gate electrode and a surface obtained by extending an edge of the top gate electrode along the width direction of the groove.

In a fifth embodiment of this application, a cross-section shape of the groove is close to a rectangle (or similar to a rectangle), and two gate electrodes are disposed in the groove. The two gate electrodes are electrically connected, and the two gate electrodes are arranged along a depth direction of the groove. In addition, the two gate electrodes are discontinuous. The two gate electrodes may be respectively an upper gate electrode and a lower gate electrode. For ease of description, an area exactly opposite to the outer side wall of the upper gate electrode in the inner side wall of the groove is referred to as an upper area, and an area exactly opposite to the outer side wall of the lower gate electrode in the inner side wall of the groove is referred to as a lower area.

It should be noted that, when two gate electrodes are disposed in the groove, the "the bottom of the gate electrode" in "between the groove bottom of the groove and the bottom of the gate electrode" mentioned above is specifically a bottom of the lower gate electrode. Correspondingly, "the bottom of the gate electrode" in "the bottom of the gate electrode faces the bottom of the groove" is also the bottom of the lower gate electrode.

Optionally, the first oxidized layer between the lower area and the outer side wall of the lower gate electrode is a gate oxidized layer, and the first oxidized layer between the upper area and the outer side wall of the upper gate electrode is a field oxidized layer.

Optionally, the first oxidized layer between the lower area and the outer side wall of the lower gate electrode is a field oxidized layer, and the first oxidized layer between the upper area and the outer side wall of the upper gate electrode is a field oxidized layer.

In addition, there is an insulation layer in an area, in the groove, obtained by extending an area between the two gate electrodes along the width direction of the groove.

In a sixth embodiment of this application, a cross-section shape of the groove is close to a convex shape (or similar to a convex shape), and an upper gate electrode and a lower gate electrode are disposed in the groove. The upper gate electrode is located in a main part of the groove, and the lower gate electrode is located in a protruding part of the groove.

It may be implemented that a first oxidized layer between an outer side wall of the lower gate electrode and an inner side wall of the protruding part is a gate oxidized layer, and a first oxidized layer between an outer side wall of the upper gate electrode and an inner side wall of the main part is a field oxidized layer.

In addition, there is an insulation layer in an area, in the groove, obtained by extending an area between the two gate electrodes (an area between a bottom of the upper gate electrode and a top surface of the lower gate electrode) along the width direction of the groove.

In a seventh embodiment of this application, a top surface of the upper gate electrode is inside the groove. Compared with the fifth and the sixth embodiments described above, there is further an insulation layer in the groove. The insulation layer is in a top area, and the top area is an area between an extension surface of a top surface of the upper gate electrode and a plane on which an outer surface of the epitaxial layer is located. The extension surface of the top surface of the upper gate electrode includes the top surface of the upper gate electrode and a surface obtained by extending an edge of the upper gate electrode along the width direction of the groove.

In addition, the power semiconductor device provided in this application is based on a dual-RESURF technology using a longitudinal field plate and an internal longitudinal diode structure, greatly reducing a chip area. In terms of performance, a switching speed is high, and when the power semiconductor device serves as an overvoltage protection device, security is high. In terms of reliability, in the present invention, a withstand voltage of a power stage and the gate electrode is the same as a forward/reverse withstand voltage of the device. There is no reliability risk of gate oxidized layer degradation or breakdown.

To verify a technical effect of the power semiconductor device in Embodiment 1 of this application, a structure and a performance parameter of the device in this embodiment of this application are simulated by using a semiconductor TCAD tool (semiconductor device technology computer aided design tool).

The simulation experiment is based on a trench gate lateral MOS-type semiconductor device with a bidirectional blocking voltage of 28 V. FIG. 9 and Table 2 show cell structural parameters of a device. On a P-type substrate with a concentration of 7 x 10¹⁹, a P-type epitaxial layer with a doping concentration of 8 x 10¹⁵ and a thickness "3" (3 herein is a number 3 in Table 2) of 2 um is set to form the device body. An N-type drift region with a concentration of 1.1 x 10¹⁷ is formed on a surface of the device body, a depth "4" (4 herein is a number 4 in Table 2) is 0.5 um, and a transverse width "1" (1 herein is a number 1 in Table 2) is 1.3 um. A width "6" (6 herein is a number 6 in Table 2) of a first part of the groove is 0.3 um, and a depth "9" (9 herein is a number 9 in Table 2) of the first part of the groove is 0.25 um. A width "7" (7 herein is a number 7 in Table 2) of a second part of the groove is 0.2 um, and a depth "8" (8 herein is a number 8 in Table 2) of the second part of the groove is 0.3um. A concentration of a P-type well region of a first doping type is 1.6 x 10¹⁷, and a depth "10" (10 herein is a number 10 in Table 2) is 0.4 um. A thickness "11" of a field oxidized layer (11 herein is a number 11 in Table 2) is set to 500 Å, and a thickness of a gate oxidized layer is set to 120 Å. A channel length of the device is basically equal to a width of a second part of the groove, and is 0.2 um. A threshold voltage of the device depends on the thickness of the gate oxidized layer and the concentration of the P-type well region of the first doping type. A breakdown voltage and an on resistance of the device are determined by a concentration, a depth, and a length of an N-type drift region, a thickness of the field oxidized layer, and a depth of the groove.

**Table 2: Cell structural parameters of a power semiconductor device provided in Embodiment 1 of this application**

| Number | Structure name | Parameter value | Number | Structure name (unit) | Parameter value |
|---|---|---|---|---|---|
| 1 | Cell size | 1.3 um | 7 | Width of a second part of a groove | 0.2 um |
| 2 | Thickness of a P-type substrate | 1 um | 8 | Depth of a second part of a groove | 0.3 um |
| 3 | Thickness of a P-type epitaxial layer | 2 um | 9 | Depth of a first part of a groove | 0.25 um |
| 4 | Depth of a second doped N-type well | 0.5 um | 10 | Depth of a P-type second well region | 0.4 um |
| 5 | Width of a heavily-doped N-type well region | 0.4 um | 11 | Thickness of a field oxidized layer | 500 Å |
| 6 | Width of a first part of a groove | 0.3 um | 12 | Depth of a heavily-doped N-type well region | 0.2 um |

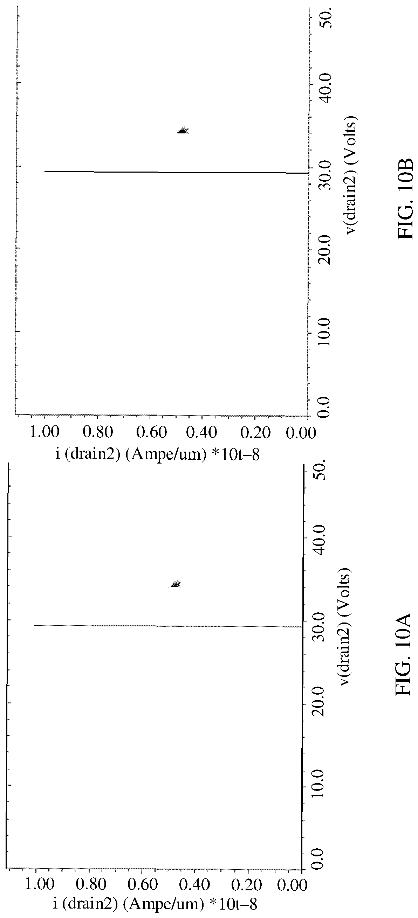

FIG. 10A and FIG. 10B are simulation curve diagrams of a breakdown voltage of a power semiconductor device according to Embodiment 1 of this application. FIG. 10A is a simulation curve diagram of a breakdown voltage of a device from a first drain electrode 581 to a second drain electrode 582, and FIG. 10B is a simulation curve diagram of a breakdown voltage of a device from the second drain electrode 582 to the first drain electrode 581.

When a potential of a gate electrode 54, a potential of a channel 59 (body), and a potential of the second drain electrode 582 are all low electrical levels, a voltage of the first drain electrode 581 gradually increases from 0 V, and a current of the first drain electrode 581 is read gradually. A voltage of the first drain electrode 581 corresponding to an abruptly increased current of the first drain electrode 581 is a breakdown voltage from the first drain electrode 581 to the second drain electrode 582 of the device. As shown in FIG. 10A, a forward withstand voltage of the device, namely, a breakdown voltage from the first drain electrode 581 to the second drain electrode 582 is 30 V. Similarly, as shown in FIG. 10B, a reverse withstand voltage of the device, namely, a breakdown voltage from the second drain electrode 582 to the first drain electrode 581 is 30 V.

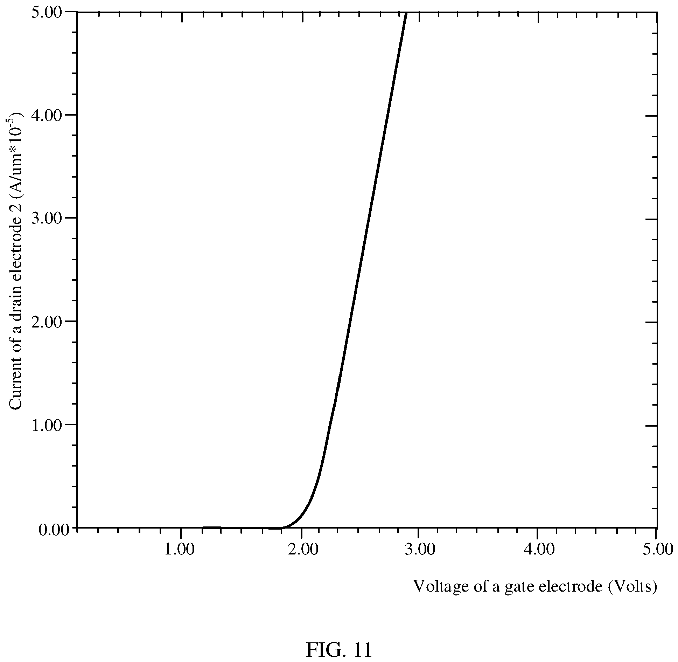

In addition, Embodiment 1 of this application further provides a threshold voltage simulation experiment of a trench gate lateral MOS-type semiconductor device with a bidirectional blocking voltage of 28 V. A simulation curve is shown in FIG. 11. Conditions of the simulation experiment are as follows: Both a channel region 59 and the second drain electrode 582 are connected to a low electrical level, the first drain electrode 581 is connected to a fixed voltage 1 V, a voltage of the gate electrode gradually increases from 0 V, and a current of the first drain electrode 581 is read gradually. A voltage of a gate electrode corresponding to an abruptly increased current of the first drain electrode 581 is a turn-on threshold voltage of the device, and a simulation result of the threshold voltage is 1.5 V.

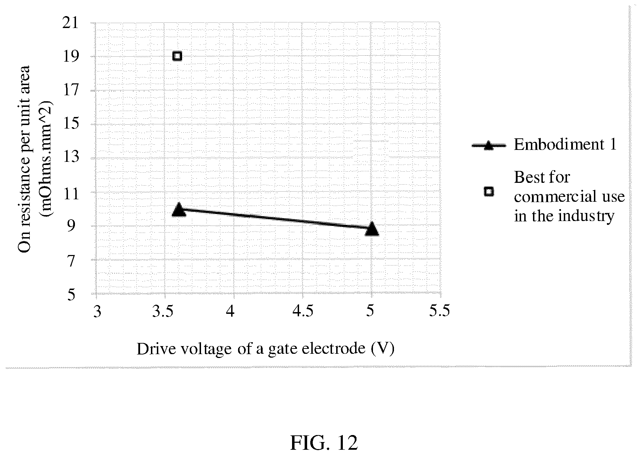

Embodiment 1 of the present invention further provides a measurement (calculation) experiment on an on resistance of a gate literal MOS-type semiconductor device with a bidirectional blocking voltage of 28 V. Simulation conditions of the measurement (calculation) experiment are as follows: Both a channel and the second drain electrode 582 are connected to a low electrical level, a voltage of the gate electrode is a fixed value 3.6 V or 5 V. An I-V characteristic of a voltage and a current of the first drain electrode 581 is simulated, and an on resistance of the device from the first drain electrode 581 to the second drain electrode 582 is calculated by using a formula R = V/I. A simulation calculation result is shown in FIG. 12. An on resistance per unit area of the device is 8.5 mΩ.mm² when a drive voltage of the gate electrode is 5 V, and is 10 mΩ.mm² when a drive voltage of the gate electrode is 3.6 V.

It can be learned from the foregoing simulation experiment result that the on resistance per unit area of the power semiconductor device provided in Embodiment 1 of this application is greatly reduced. The following experimental data can be used to further verify the effect: When a gate electrode drive voltage is 3.6 V, an on resistance per unit area of a conventional literal MOS device with a bidirectional blocking voltage of 30 V that is the best for commercial use in the industry is 19 mΩ.mm². An on resistance per unit area of the power semiconductor device in this embodiment of this application is 10 mΩ.mm². and is 50% less than the best for commercial use in the industry.

The foregoing is a specific implementation of the power semiconductor device according to Embodiment 1 of this application. Based on the specific implementation, Embodiment 1 of this application further provides a specific implementation of a manufacturing method of a power semiconductor device.

It should be noted that the power semiconductor device provided in Embodiment 1 of this application may be implemented based on a conventional split trench gate MOS process or a monolithic integrated BCD process technology, and a manufacturing process is simple and manufacturing costs are low.

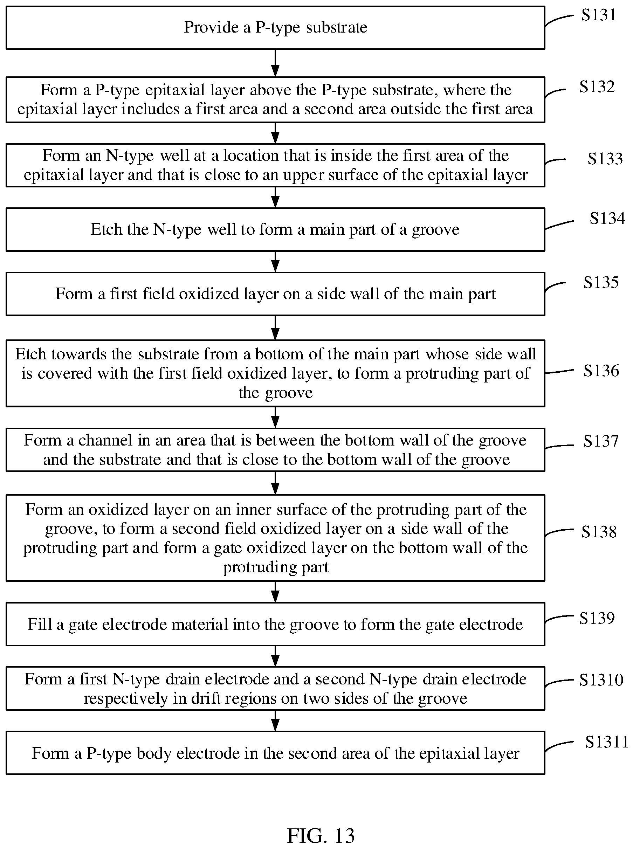

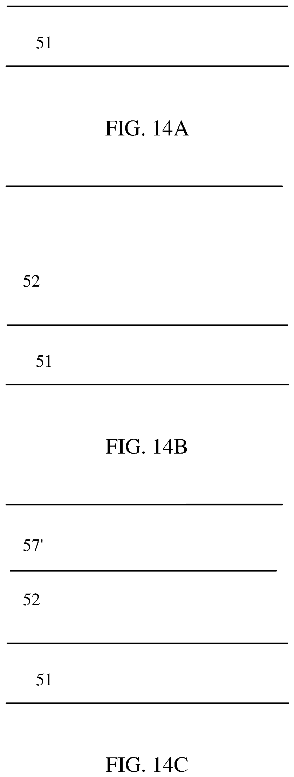

FIG. 13 is a schematic flowchart of a manufacturing method of a power semiconductor device according to Embodiment 1 of this application. FIG. 14A to FIG. 14I are schematic cross-sectional structural diagrams corresponding to a series of manufacturing procedures of a manufacturing method of a power semiconductor device according to Embodiment 1 of this application.

As shown in FIG. 13, the manufacturing method of the power semiconductor device includes the following steps.

S131: Provide a P-type substrate.

In this embodiment of this application, the P-type substrate 51 may be a silicon substrate.

FIG. 14A is a schematic cross-sectional structural diagram of the P-type substrate.

S132: Form a P-type epitaxial layer above the P-type substrate, where the epitaxial layer includes a first area and a second area outside the first area.

This step may specifically be: The P-type epitaxial layer 52 with a specific doping concentration grows on the P-type substrate 51.

It should be noted that the first area is an area in which a cell is located, and the second area is a contact area of a body electrode. As shown in FIG. 4, an area in which the cell 50 is located is the first area, and the contact area of a body electrode 510 is the second area.

The P-type epitaxial layer 52 may be used as a device body. The P-type epitaxial layer 52 includes a first area I and a second area II. FIG. 14B is a schematic cross-sectional structural diagram after this step is performed.

S133: Form an N-type well at a location that is inside the first area of the epitaxial layer and that is close to an upper surface of the epitaxial layer.

This step may specifically be: N-type doping impurity ions are injected, through ion injection, to the location that is inside the first area I of the epitaxial layer 52 and that is close to the upper surface of the epitaxial layer, to form the N-type well 57', so that an N-type drift region is formed at the location that is inside the first area I of the epitaxial layer 52 and that is close to the upper surface of the epitaxial layer.

FIG. 14C is a schematic cross-sectional structural diagram after this step is performed.

S134: Etch the N-type well to form a main part of a groove.

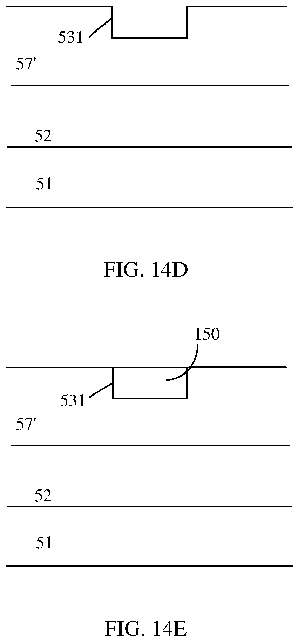

The N-type well 57' is etched by using a silicon etching process to form the main part 531 of the groove in the N-type well 57'. FIG. 14D is a schematic cross-sectional structural diagram after this step is performed.

S135: Form a first field oxidized layer on a side wall of the main part.

In an example, the S135 may be implemented in the following implementation, including the following steps.

S1351: Fill up silicon dioxide into the main part.

The silicon dioxide 150 is filled up into the main part 531 by using a thermal growth or silicon dioxide deposition process. FIG. 14E is a schematic cross-sectional structural diagram after this step is performed.

S1352: Etch silicon dioxide in a middle area of the main part to form the first field oxidized layer on the side wall of the main part of the groove.

This step may specifically be: etching, based on a thickness of the first field oxidized layer, the silicon dioxide 150 in the middle area of the main part 531, to form the first field oxidized layer 551 on the side wall of the main part 531.

It should be noted that the thickness of the first field oxidized layer determines voltage withstand performance of the power semiconductor device. Therefore, the thickness of the first field oxidized layer may be determined based on the voltage withstand performance of the manufactured power semiconductor device. For example, the thickness of the first field oxidized layer may be 0.1 um.

S136: Etch towards the substrate from a bottom of the main part whose side wall is covered with the first field oxidized layer, to form a protruding part of the groove.

This step may specifically be: etching towards the substrate from the bottom of the main part whose side wall is covered with the first field oxidized layer, to form the protruding part 532 of the groove. It should be noted that the protruding part 532 of the groove may be extended to the epitaxial layer 52.

It should be noted that, in this embodiment of this application, the main part 531 and the protruding part 532 form the groove 53.

Correspondingly, the N-type well 57' located outside the main part 531 and the protruding part 532 of the groove is used as the drift region 57.

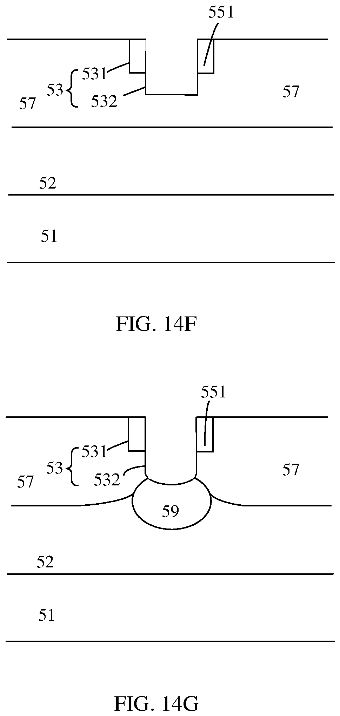

FIG. 14F is a schematic cross-sectional structural diagram after this step S136 is performed.

S137: Form a channel between the bottom wall of the groove and the substrate and that is close to an area of the bottom wall of the groove.

This step may specifically be: P-type doping ions are injected to the bottom wall of the protruding part 532, to form a P-type well region 59 between the bottom wall of the protruding part 532 and the substrate 51 and that is close to an area of the bottom wall of the groove 532, where the P-type well region is used as a channel 59 of the power semiconductor device.

FIG. 14G is a schematic cross-sectional structural diagram after this step is performed.

S138: Form an oxidized layer on an inner surface of the protruding part of the groove, to form a second field oxidized layer on a side wall of the protruding part and form a gate oxidized layer on the bottom wall of the protruding part.

A function of the oxidized layer formed on the bottom wall of the protruding part 532 is the gate oxidized layer. A quality and a thickness of the gate oxidized layer are crucial for the threshold voltage of the gate electrode. Therefore, to improve a quality of a film of the generated oxidized layer, this step may be specifically: forming the oxidized layer on the inner surface of the protruding part 532 by using a thermal growth process. An oxidized layer may be formed at the bottom and on the side wall of the protruding part 532 by using the thermal growth process. The oxidized layer formed on the bottom wall of the protruding part 532 is a gate oxidized layer 56, and the oxidized layer formed on the side wall of the protruding part 532 is a second field oxidized layer 552.

It should be noted that, in this embodiment of this application, because a thickness of the gate oxidized layer is relatively thin, the oxidized layer that is formed on the inner surface of the protruding part 532 is a thin layer oxidized layer. Generally, a thickness of the oxidized layer is less than a thickness of the first field oxidized layer that covers the side wall of the main part 531. In this way, a thickness of the second field oxidized layer is less than the thickness of the first field oxidized layer. In this way, when the threshold voltage and the withstand voltage of the power semiconductor device are satisfied, the power semiconductor device may have a relatively small on resistance.

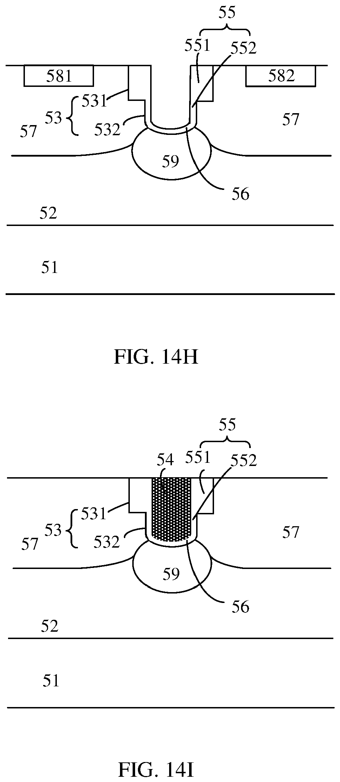

FIG. 14H is a schematic cross-sectional structural diagram after this step is performed.

S139: Fill a gate electrode material into the groove to form the gate electrode.

This step may specifically be: Polysilicon is filled into the groove 53, to form a polysilicon gate electrode 54 in the groove 53. It should be noted that, after the polysilicon is filled, to reduce a quantity of mask layers, the polysilicon may be further ground by using a chemical mechanical grinding process after the polysilicon is filled.

It should be noted that, in this embodiment of this application, a width of the formed gate electrode 54 along a thickness direction of the epitaxial layer may not change. In another example, a width of the gate electrode along the thickness direction of the epitaxial layer may alternatively change. In this way, along the thickness direction of the epitaxial layer, the gate electrode 54 may include a first part and a second part that extends from the first part to the bottom wall of the groove 53, and a width of the first part is greater than a width of the second part. In addition, the first part of the gate electrode is located in the main part 531 of the groove, and the second part of the gate electrode is located in the protruding part 532 of the groove.

FIG. 14I is a schematic cross-sectional structural diagram after this step is performed.

S1310: Form a first N-type drain electrode and a second N-type drain electrode respectively in drift regions on two sides of the groove.

This step may specifically be: Heavily-doped N-type doping ions are respectively injected to surfaces of the drift regions on the two sides of the groove, to form the first N-type drain electrode 581 and the second N-type drain electrode 582 in the drift regions on the two sides of the groove. It should be noted that, in a specific example, the first N-type drain electrode 581 and the second N-type drain electrode 582 may be symmetrically distributed on the two sides of the groove, to form a bidirectional-voltage-withstand MOS-type switch device.

S1311: Form a P-type body electrode in the second area of the epitaxial layer.

To implement miniaturization of the device, in an optional embodiment of this application, P-type doping ions may be injected to a surface of the second area of the epitaxial layer 52 to form a heavily-doped P-type well, where the heavily-doped P-type well is used as the P-type body electrode 510. It should be noted that, in this embodiment of this application, all cells are located in an area enclosed by the body electrode 510.

FIG. 5 is a schematic cross-sectional structural diagram after this step is performed.

The foregoing is a specific implementation of the manufacturing method of the power semiconductor device according to Embodiment 1 of this application. In the specific implementation, the manufacturing method of the power semiconductor device may be implemented based on a conventional split trench gate MOS process or a monolithic integrated BCD process technology. A manufacturing process is simple, and manufacturing costs are low.

The foregoing is a specific implementation of the power semiconductor device and the manufacturing method of the power semiconductor device according to Embodiment 1 of this application. In addition, to improve current uniformity between cells, this application further provides another specific implementation of a power semiconductor device and a manufacturing method of the power semiconductor device. For details, refer to Embodiment 2.

### Embodiment 2

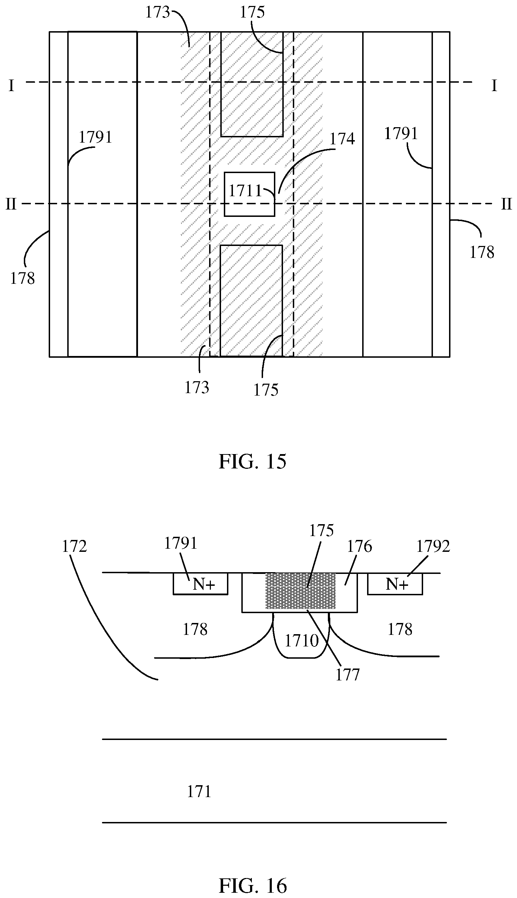

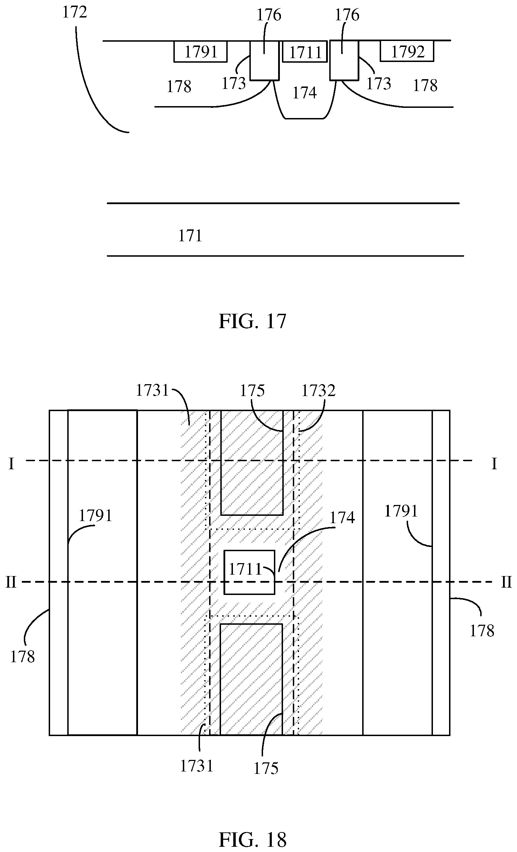

FIG. 15 is a schematic top view of a power semiconductor device according to Embodiment 2 of this application. FIG. 16 is a schematic cross-sectional structural diagram of a power semiconductor device along a direction of I-I in FIG. 15 according to Embodiment 2 of this application. FIG. 17 is a schematic cross-sectional structural diagram of a power semiconductor device along a direction of II-II in FIG. 15 according to Embodiment 2 of this application.

It should be noted that a schematic diagram of a device symbol of a power semiconductor device in Embodiment 2 is the same as the schematic diagram of the device symbol in Embodiment 1. For brevity, the schematic diagram of the symbol is not shown in this embodiment of this application. For details, refer to the schematic diagram of the device symbol in Embodiment 1.

As shown in FIG. 15 to FIG. 17, a power semiconductor device provided in Embodiment 2 of this application includes:
a P-type substrate 171;
a P-type epitaxial layer 172 located on one side of the substrate 171;
a groove 173 located in the epitaxial layer 172, where a P-type well region 174 of an isolated island shape and a gate electrode 175 are disposed in the groove 173, a side wall of the groove 173 is covered with a field oxidized layer 176, a specific area of a bottom wall of the groove 173 is covered with a gate oxidized layer 177, and the specific area is an area covered by a front projection of a bottom of the gate electrode 174 on the bottom wall of the groove 173;
N-type drift regions 178 disposed on two sides of the groove 173, where the field oxidized layer 176 and the drift regions 178 overlap in a transverse direction of a cell;
a first drain electrode 1791 and a second drain electrode 1792 that are disposed in the drift regions 178 on the two sides of the groove 173; and both the first drain electrode 1791 and the second drain electrode 1792 are an N type; and
a P-type channel 1710 disposed below the groove 173.

To form more body electrodes and further improve current equalization of the cell, in this embodiment of this application, the device may further include a body electrode 1711 formed in the P-type well region 174. The body electrode 1711 is formed in the P-type well region 174 and is close to an outer surface of the P-type well region 174. A doping type of the body electrode 1711 is P type. In this way, a body electrode is formed on each cell, so that a cell having the body electrode is formed. In this way, current equalization between cells may be improved.

In addition, to improve voltage withstand performance of the device, in an optional embodiment of this application, the field oxidized layer 176 may be disposed surrounding the P-type well region 174.

It should be noted that, in this embodiment of this application, the P-type channel 1710 and the P-type well region 174 may be formed at the same time, and the P-type channel 1710 and the P-type well region 174 may be of an integrally formed structure, and may be formed by injecting doping ions to a part area on a surface of the epitaxial layer. It may be considered that the P-type channel 1710 and the P-type well region 174 are different parts of the P-type well region formed by injecting P-type doping ions to a part area on the surface of the epitaxial layer. The specific implementation is described in detail in the manufacturing method of the power semiconductor device.

Widths of the gate electrode 175 along a thickness direction of the epitaxial layer may be the same. In another example, widths of the gate electrode 175 along the thickness direction of the epitaxial layer may alternatively be different. In this way, along the thickness direction of the epitaxial layer, the gate electrode 175 may include a first part and a second part that extends from the first part to the bottom wall of the groove 173, and a width of the first part is greater than a width of the second part. In addition, the first part of the gate electrode is located in the main part 1731 of the groove, and the second part of the gate electrode is located in the protruding part 1732 of the groove. In another example, the gate electrode 175 may be a polycrystalline silicon gate electrode.

In addition, to implement bidirectional voltage withstand of the power semiconductor device, in an example, the first drain electrode 1791 and the second drain electrode 1792 are symmetrically distributed on the two sides of the groove 173.

In this embodiment of this application, widths of the groove 173 along a thickness direction of the epitaxial layer may be the same. In this way, in this example, a shape of a longitudinal cross-section of the groove 173 is a rectangle. In this way, the groove may be formed by using a sequential etching process. A manufacturing process is relatively simple, and manufacturing costs are relatively low.

In addition, to further reduce an on resistance per unit area of the device based on a premise that a withstand voltage of the device is ensured, in an optional embodiment of this application, widths of the groove 173 along the thickness direction of the epitaxial layer may alternatively be different. In this way, in this example, the groove 173 is a convex groove. A structure of the semiconductor device in the optional embodiment is shown in FIG. 18 to FIG. 20.

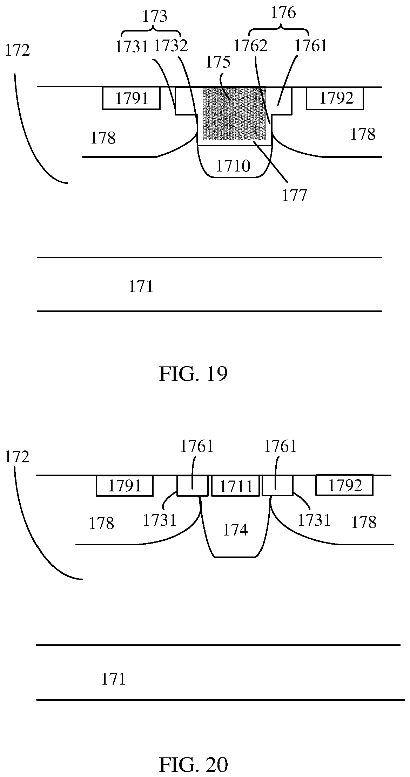

FIG. 18 is a schematic top view of another power semiconductor device according to Embodiment 2 of this application. FIG. 19 is a schematic cross-sectional structural diagram of another power semiconductor device along a direction of I-I in FIG. 18 according to Embodiment 2 of this application. FIG. 20 is a schematic cross-sectional structural diagram of another power semiconductor device along a direction of II-II in FIG. 18 according to Embodiment 2 of this application.

It should be noted that a structure of the power semiconductor device shown in FIG. 18 to FIG. 20 has some similarities with the structure of the power semiconductor device shown in FIG. 15 to FIG. 17. A difference lies only in a shape of the groove. For brevity, only the difference thereof is described herein.

FIG. 18 to FIG. 20 are schematic structural diagrams of a power semiconductor device. The groove 173 may include a main part 1731 and a protruding part 1732 that extends from the main part 1731 and protrudes towards a substrate 171. It should be understood that a width of the main part 1731 is greater than a width of the protruding part 1732. The structure of the groove 173 may also be understood in the following manner: The groove is a convex groove, a protruding part of the convex groove protrudes towards the substrate, and an opening of the convex groove faces an upper surface of the epitaxial layer.

When the groove 173 is a convex groove, correspondingly, the field oxidized layer 176 may include a first field oxidized layer 1761 along a side wall of the main part 1731 and a second field oxidized layer 1762 along a side wall of the protruding part 1732. In addition, to reduce an on resistance of the semiconductor device, a thickness of the first field oxidized layer 1761 is greater than a thickness of the second field oxidized layer 1762.

In addition, when the groove 173 is the convex groove, correspondingly, the N-type drift regions 178 are located outside the main part 1731 and the protruding part 1732 of the groove.

It should be noted that, in this embodiment of this application, the first field oxidized layer 1761 may be formed by depositing silicon dioxide by using an oxide deposition process. The second field oxidized layer 1762 may be generated in a thermal oxidation manner.

In a specific example, the second field oxidized layer 1762 and the gate oxidized layer 177 may be formed at the same time.

The foregoing is a specific implementation of the power semiconductor device according to Embodiment 2 of this application. In this specific implementation, the power semiconductor device not only has the beneficial effects of the power semiconductor device provided in Embodiment 1, but also has relatively good current equalization between cells.

To verify a technical effect of the power semiconductor device in Embodiment 2 of this application, a structure and a performance parameter of the device in this embodiment of this application are simulated by using a semiconductor TCAD tool (semiconductor device technology computer aided design tool).

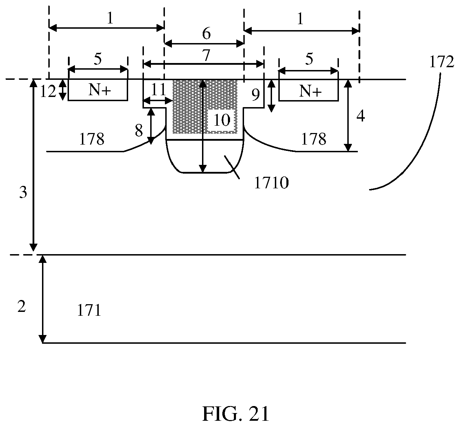

The simulation experiment is based on a trench gate lateral MOS-type semiconductor device with a bidirectional blocking voltage of 28 V. FIG. 21 and Table 3 show cell structural parameters of a device.

On a P-type substrate with a concentration of 7 x 10¹⁹, a P-type epitaxial layer with a doping concentration of 8 x 10¹⁵ and a thickness "3" (3 herein is a number 3 in Table 3) of 2 um is set to form the device body. A width "7" (7 herein is a number 7 in Table 3) of a first part of the groove is 0.4 um, and a depth "9" (9 herein is a number 9 in Table 3) of the first part of the groove is 0.2 um. A width "6" (6 herein is a number 6 in Table 3) of a second part of the groove is 0.3 um, and a depth "8" (8 herein is a number 8 in Table 3) is 0.2 um. On a surface of the device body, and N-type drift regions with a concentration of 8 x 10¹⁶ are respectively disposed on the two sides of the groove, a depth "4" (5 herein is a number 5 in Table 3) is 0.5 um, and a transverse width "5" (5 herein is a number 7 in Table 5) is 0.5 um. A concentration of a P-type well region of a first doping type is 1.7 x 10¹⁷, and a depth "10" (10 herein is a number 10 in Table 3) is 0.9 um. A thickness "11" of a field oxidized layer (11 herein is a number 11 in Table 3) is set to 500 Å, and a thickness of a gate oxidized layer is set to 120 Å. A channel length of the device is basically equal to a width of a second part of the groove, and is 0.3 um. A threshold voltage of the device depends on the thickness of the gate oxidized layer and the concentration of the P-type well region of the first doping type. A breakdown voltage and an on resistance of the device are determined by a concentration, a depth, and a length of an N-type drift region, a thickness of the field oxidized layer, and a depth of the groove.

**Table 3: Cell structural parameters of a device in Embodiment 2**

| Number | Structure name | Parameter value | Number | Structure name (unit) | Parameter value |
|---|---|---|---|---|---|
| 1 | Width of a second doped N-type well | 0.5 um | 7 | Width of a first part of a groove | 0.4 um |
| 2 | Thickness of a P-type substrate | 1 um | 8 | Depth of a second part of a groove | 0.2 um |
| 3 | Thickness of a P-type epitaxial layer | 2 um | 9 | Depth of a first part of a groove | 0.2 um |
| 4 | Depth of a second doped N-type well | 0.5 um | 10 | Depth of a P-type second well region | 0.9 um |
| 5 | Width of a heavily-doped N-type well region | 0.4 um | 11 | Thickness of a field oxidized layer | 500 Å |
| 6 | Width of a second part of a groove | 0.3 um | 12 | Depth of a heavily-doped N-type well region | 0.15 um |

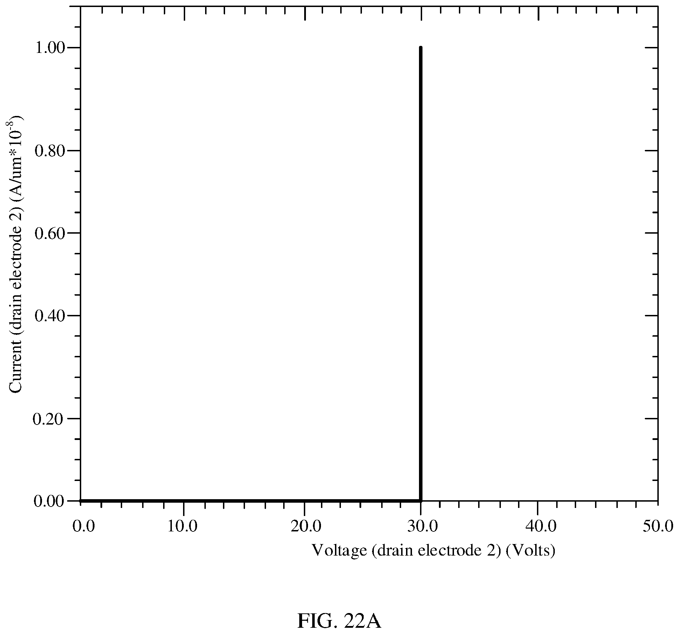

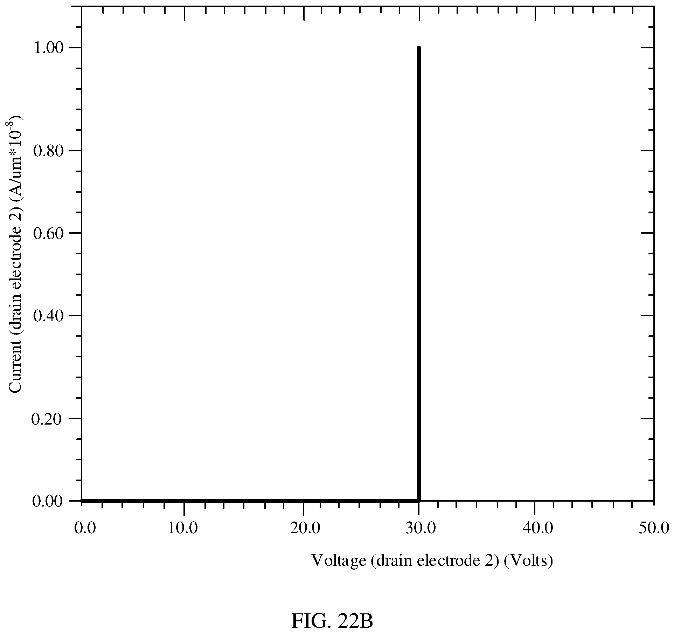

FIG. 22A and FIG. 22B are simulation curve diagrams of a breakdown voltage of a device according to Embodiment 2. When a potential of a gate electrode, a potential of a channel (body), and a potential of the second drain electrode are all low electrical levels, a voltage of the first drain electrode gradually increases from 0 V, and a current of the first drain electrode 1791 is read gradually. A voltage of the first drain electrode 1791 corresponding to an abruptly increased current of the first drain electrode 1791 is a breakdown voltage from the first drain electrode 1791 to the second drain electrode 1792 of the device. As shown in FIG. 22A, a forward withstand voltage of the device, namely, a breakdown voltage from the first drain electrode 1791 to the second drain electrode 1792 is 29 V. Similarly, as shown in FIG. 22B, a reverse withstand voltage of the device, namely, a breakdown voltage from the second drain electrode 1792 to the first drain electrode 1791 is 29 V.

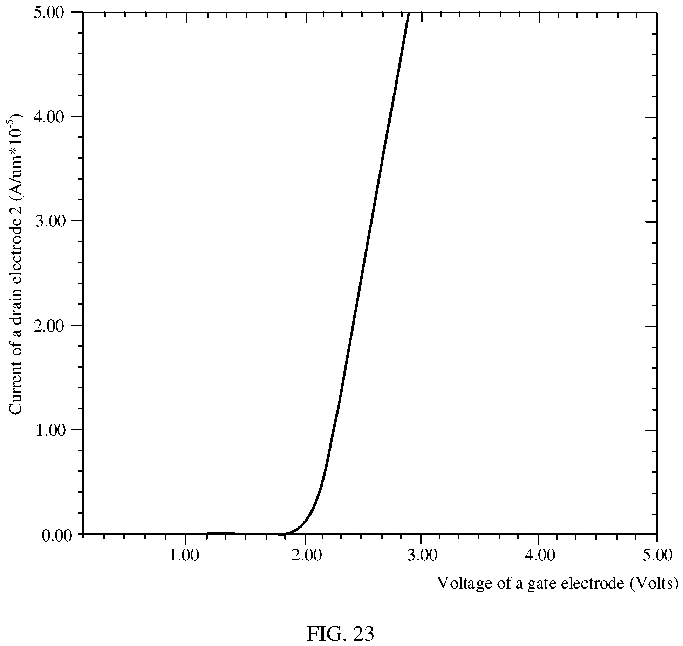

FIG. 23 is a simulation curve diagram of a threshold voltage of the device in Embodiment 2 of the present invention. Both a channel 1710 and the second drain electrode 1792 are connected to a low electrical level, the first drain electrode 1791 is connected to a fixed voltage 1 V, a voltage of the gate electrode gradually increases from 0 V, and a current of the first drain electrode 1791 is read gradually. A voltage of a gate electrode corresponding to an abruptly increased current of the first drain electrode 1791 is a turn-on threshold voltage of the device, and a simulation result of the threshold voltage is 1.5 V.

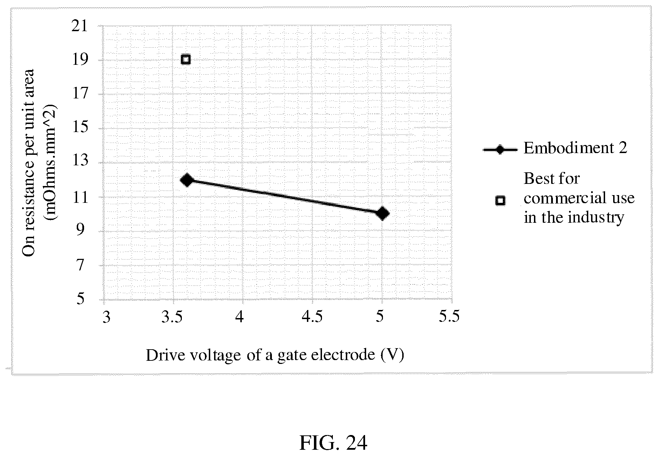

Embodiment 2 of the present invention further provides a measurement (simulation calculation) experiment on an on resistance of a gate literal MOS-type semiconductor device with a bidirectional blocking voltage of 28 V. Simulation conditions of the measurement (simulation calculation) experiment are as follows: Both a channel and the second drain electrode 1792 are connected to a low electrical level, a voltage of the gate electrode is a fixed value 3.6 V or 5 V. An I-V characteristic of a voltage and a current of the first drain electrode 1791 is simulated, and an on resistance of the device from the first drain electrode 1791 to the second drain electrode 1792 is calculated by using a formula R = V/I. A simulation calculation result is shown in FIG. 24. An on resistance per unit area of the device is 9.5 mΩ.mm² when a drive voltage of the gate electrode is 5 V, and is 12 mΩ.mm² when a drive voltage of the gate electrode is 3.6 V.

It can be learned from the foregoing simulation experiment result that the on resistance per unit area of the power semiconductor device provided in Embodiment 2 of this application is greatly reduced. The following experimental data can be used to further verify the effect: When a gate electrode drive voltage is 3.6 V, an on resistance per unit area of a conventional literal MOS device with a bidirectional blocking voltage of 30 V that is the best for commercial use in the industry is 19 mΩ.mm². An on resistance per unit area of the power semiconductor device in Embodiment 2 of this application is 12 mΩ.mm². and is 37% less than the best for commercial use in the industry.

In addition, a switching speed of the power semiconductor device provided in Embodiment 2 of this application is also relatively high.

Based on the specific structure of the power semiconductor device provided in Embodiment 2, an embodiment of this application further provides a specific implementation of a manufacturing method of a power semiconductor device.

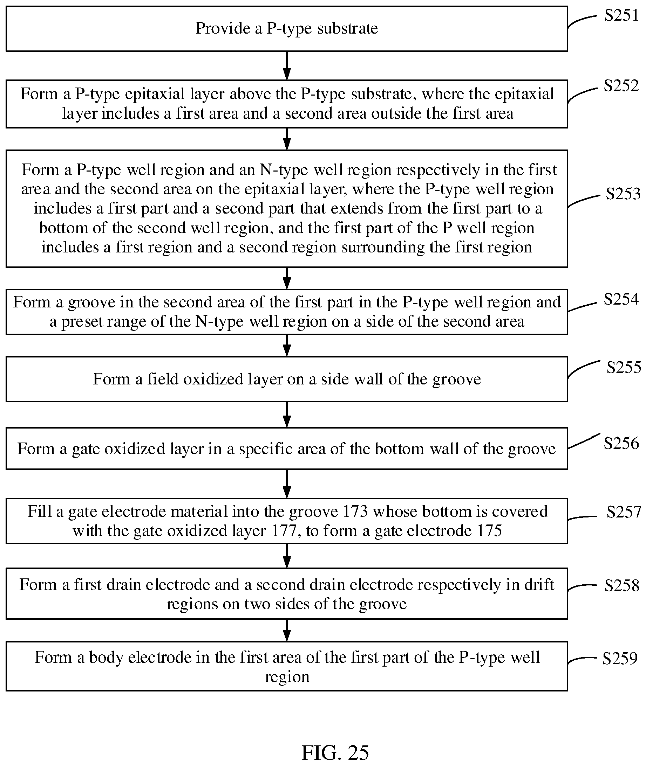

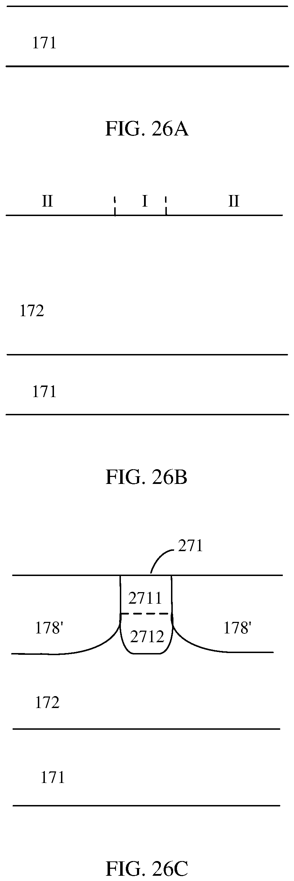

FIG. 25 is a schematic flowchart of a manufacturing method of a power semiconductor device according to Embodiment 2 of this application. FIG. 26A to FIG. 26I are schematic structural diagrams corresponding to a series of manufacturing procedures of a manufacturing method of a power semiconductor device according to Embodiment 2 of this application.

As shown in FIG. 25, the manufacturing method of the power semiconductor device provided in Embodiment 2 of this application includes the following steps.

S251: Provide a P-type substrate.

In this embodiment of this application, the P-type substrate 171 may be a silicon substrate. FIG. 26A is a schematic cross-sectional structural diagram of the P-type substrate.

S252: Form a P-type epitaxial layer above the P-type substrate, where the epitaxial layer includes a first area and a second area outside the first area.

This step may specifically be: The P-type epitaxial layer 172 with a specific doping concentration grows on the P-type substrate 171.

The P-type epitaxial layer 172 may be used as a device body. The P-type epitaxial layer 172 includes a first area I and a second area II that is located at the two sides of the first area. FIG. 26B is a schematic cross-sectional structural diagram after this step is performed.

S253: Inject, through ion injection, P-type doping impurities and N-type doping impurities respectively to the first area and the second area of the epitaxial layer, to respectively form a P-type well region and an N-type well region, where the P-type well region includes a first part and a second part that extends from the first part to a bottom of the second well region, and the first part of the P well region includes a first region and a second region surrounding the first region.

This step may specifically be: The P-type doping impurities are first injected, through ion injection, to a surface of a first area I of the epitaxial layer 172 to form the P-type well region 271, and then the N-type doping impurities are injected, through ion injection, to a second area II of the epitaxial layer 172 to form an N-type well region 178'. The P-type well region 271 includes a first part 2711 and a second part 2712 that are opposite to each other, where the first part 2711 is located above the second part 2712. The first part 2711 includes a first area S1 and a second area S2 surrounding the first area S1.

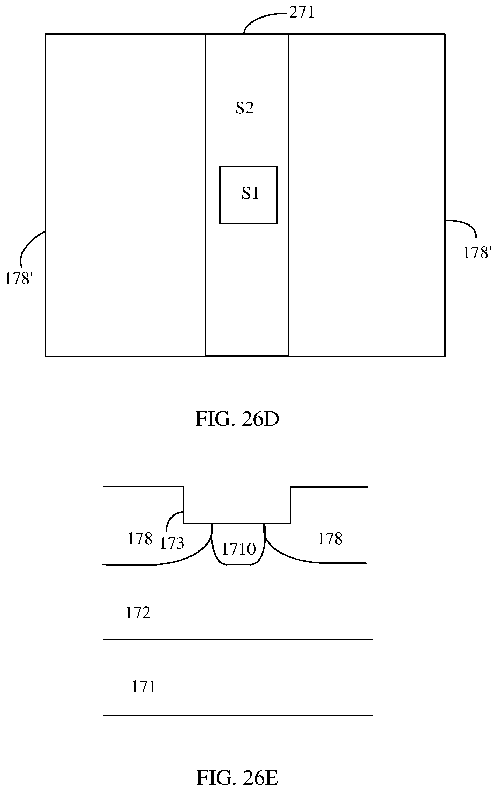

FIG. 26C is a schematic cross-sectional structural diagram after this step is performed, and FIG. 26D is a schematic structural top view after this step is performed.

S254: Form a groove in the second area of the first part in the P-type well region and a preset range of the N-type well region on a side of the second area.

To simplify a manufacturing process and reduce manufacturing costs, as an optional example, a specific implementation of S254 may specifically include:
etching a second area S2 of the first part 2711 in the P-type well region and a preset range of an N-type well region 178' on a side of the second area S2, to form a groove 173 in the second area S2 of the first part 2711 in the P-type well region and the preset range of the N-type well region 178' of the side of the second area S2.

Correspondingly, the N-type well region 178' located outside the groove 173 is used as the drift region 178. The second part 2712 of the P-type well region 271 is formed as a channel 1710.

FIG. 26E is a schematic cross-sectional structural diagram after this step is performed.

S255: Form a field oxidized layer on a side wall of the groove.

In an example, the S225 may be implemented in the following implementation, including the following steps.

S2551: Fill up silicon dioxide into the groove 173.

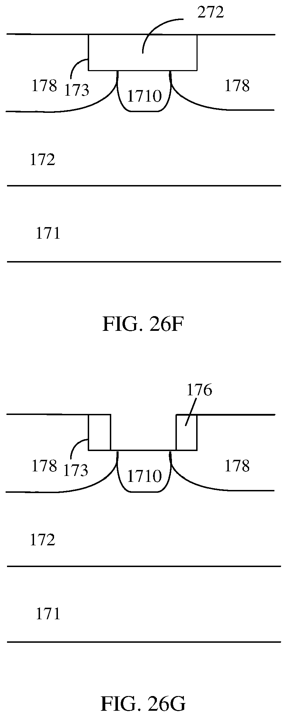

The silicon dioxide 272 is filled up into the main part 531 by using a thermal growth or silicon dioxide deposition process. FIG. 26F is a schematic cross-sectional structural diagram after this step is performed.

S2552: Etch, based on a thickness of the field oxidized layer, silicon dioxide 272 that is close to a middle area of the groove 173, to form a field oxidized layer 176 on a side wall of the groove 173.

This step may specifically be: etching, based on a thickness of the field oxidized layer, the silicon dioxide 272 in the middle area of the groove 173, to form the field oxidized layer 176 on the side wall of the groove 173. FIG. 26G is a schematic cross-sectional structural diagram after this step is performed.

It should be noted that the thickness of the field oxidized layer determines voltage withstand performance of the power semiconductor device. In an example, the thickness of the oxidized layer may be 0.1 um.

S256: Form a gate oxidized layer in a specific area of the bottom wall of the groove, and the specific area of the bottom wall of the groove is an area covered by a front projection of a bottom wall of a to-be-formed gate electrode on the bottom wall of the groove.

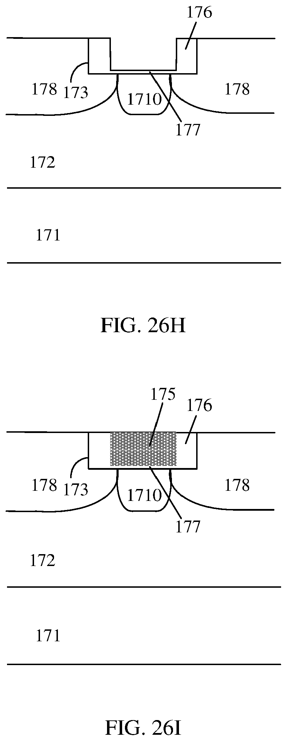

To improve a quality of the gate oxidized layer 177, in this step, the gate oxidized layer 177 may be formed at the bottom of the groove 173 by using a thermal oxidation process. FIG. 26H is a schematic cross-sectional structural diagram after this step is performed.

S257: Fill a gate electrode material into the groove 173 whose bottom is covered with the gate oxidized layer 177, to form a gate electrode 175.

In an example, a polysilicon material may be filled into a second groove whose bottom is covered with a gate oxidized layer, to form a polysilicon gate electrode 175.

FIG. 26I is a schematic cross-sectional structural diagram after this step is performed.

S258: Form a first drain electrode and a second drain electrode respectively in drift regions on two sides of the groove, and a doping type of the first drain electrode and the second drain electrode is an N type.

This step may specifically be: Heavily-doped N-type doping ions are respectively injected to surfaces of the drift regions 178 on the two sides of the groove 173, to form a first N-type drain electrode 1791 and a second N-type drain electrode 1792 in the drift regions 178 on the two sides of the groove 173. It should be noted that, in a specific example, the first N-type drain electrode 1791 and the second N-type drain electrode 1792 may be symmetrically distributed on the two sides of the groove, to form a bidirectional-voltage-withstand MOS-type switch device. FIG. 16 is a schematic cross-sectional structural diagram after this step is performed.

S259: Form a body electrode in the first area of the first part of the P-type well region.

To implement miniaturization of the device and increase current equalization of the device, in an optional embodiment of this application, P-type doping ions may be injected to a surface of a first area s1 of the first part 2711 of the P-type well region 271 to form a heavily-doped P-type well, where the heavily-doped P-type well is used as a P-type body electrode 1711.

FIG. 17 is a schematic cross-sectional structural diagram after this step is performed.

The foregoing is a specific implementation of the manufacturing method of the power semiconductor device according to Embodiment 2 of this application.

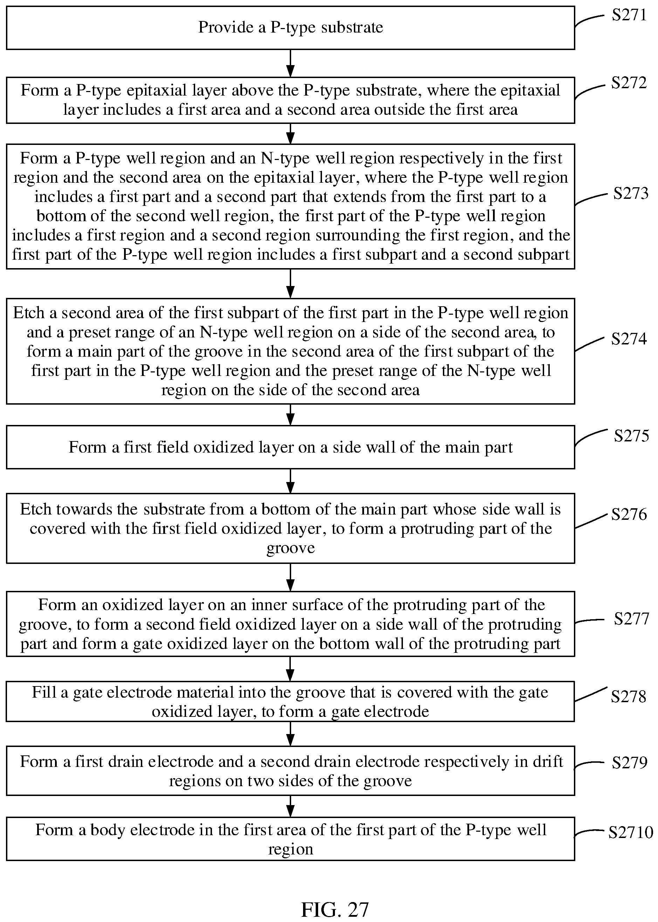

As an optional embodiment of this application, to further reduce an on resistance of a device, this application further provides another optional implementation of a manufacturing method of a power semiconductor device. Refer to FIG. 27 to FIG. 28F.

As shown in FIG. 27, another implementation of a manufacturing method of a power semiconductor device provided in this embodiment of this application includes the following steps.

S271 to S273 are the same as S251 to S253. For brevity, details are not described herein again.

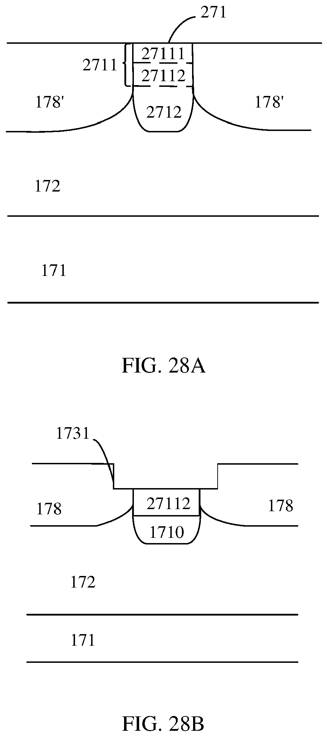

The first part 2711 of the P-type well region 271 may include a first subpart 27111 and a second subpart 27112 that extends from the first subpart 27111 to the bottom of the second well region. The first subpart 27111 of the first part 2711 of the P-type well region 271 includes a first region and a second region surrounding the first region. FIG. 28A is a schematic cross-sectional structural diagram after the P-type well region is formed.

S274: Etch a second area of the first subpart 27111 of the first part in the P-type well region and a preset range of the N-type well region 178' on a side of the second area, to form a main part 1731 of the groove in the second area of the first subpart 27111 of the first part in the P-type well region and the preset range of the N-type well region 178' on the side of the second area.

FIG. 28B is a schematic cross-sectional structural diagram after this step is performed.

S275: Form a first field oxidized layer on a side wall of the main part.

In an example, the S275 may be implemented in the following implementation, including the following steps.

S2751: Fill up silicon dioxide 281 into the main part 1731 of the groove.

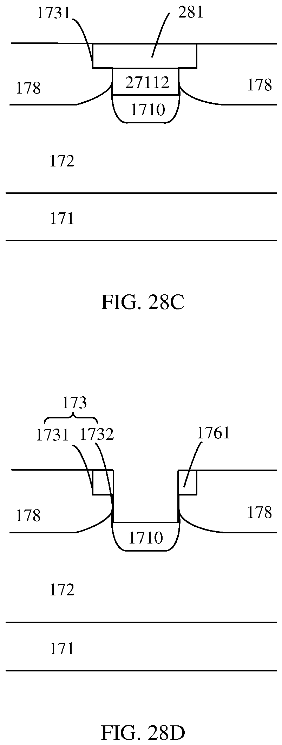

FIG. 28C is a schematic cross-sectional structural diagram after this step is performed.

S2752: Etch silicon dioxide in a middle area of the main part, to form the first field oxidized layer on the side wall of the main part of the groove.

S276: Etch towards the substrate from a bottom of the main part whose side wall is covered with the first field oxidized layer, to form a protruding part of the groove.

This step may specifically be: etching towards the substrate from the bottom of the main part whose side wall is covered with the first field oxidized layer, to form the protruding part 1732 of the groove. It should be noted that the protruding part 1732 of the groove may be extended to the epitaxial layer 172.

It should be noted that, in this embodiment of this application, the main part 1731 and the protruding part 1732 form the groove 173.

Correspondingly, the N-type well region 178' located outside the main part 1731 and the protruding part 1732 of the groove is used as the drift regions 178.

FIG. 28D is a schematic cross-sectional structural diagram after this step is performed.

S277: Form an oxidized layer on an inner surface of the protruding part 1732 of the groove, to form a second field oxidized layer 1762 on a side wall of the protruding part 1732 and form a gate oxidized layer 177 on the bottom wall of the protruding part 1732.

A function of the oxidized layer formed on the bottom wall of the protruding part 1732 is the gate oxidized layer. A quality and a thickness of the gate oxidized layer are crucial for the threshold voltage of the gate electrode. Therefore, to improve a quality of a film of the generated oxidized layer, this step may be specifically: forming the oxidized layer on the inner surface of the protruding part 1732 by using a thermal growth process. An oxidized layer may be formed at the bottom and on the side wall of the protruding part 1732 by using the thermal growth process. The oxidized layer formed on the bottom wall of the protruding part 1732 is a gate oxidized layer 177, and the oxidized layer formed on the side wall of the protruding part 1732 is a second field oxidized layer 1762.

It should be noted that, in this embodiment of this application, because a thickness of the gate oxidized layer is relatively thin, the oxidized layer that is formed on the inner surface of the protruding part 1732 is a thin layer oxidized layer. Generally, a thickness of the oxidized layer is less than a thickness of the first field oxidized layer 1761 that covers the side wall of the main part 1731. In this way, a thickness of the second field oxidized layer 1762 is less than the thickness of the first field oxidized layer 1761. In this way, when the threshold voltage and the withstand voltage of the power semiconductor device are satisfied, the power semiconductor device may have a relatively small on resistance.

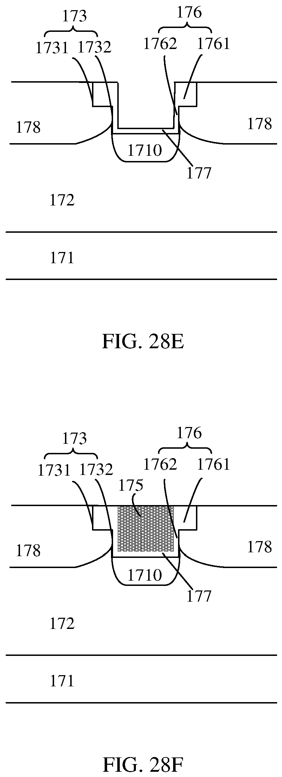

FIG. 28E is a schematic cross-sectional structural diagram after this step is performed.

S278: Fill a gate electrode material into the groove that is covered with the gate oxidized layer, to form a gate electrode.

In an example, a polysilicon material may be filled into a groove 173 that is covered with a gate oxidized layer, to form a polysilicon gate electrode 175.

FIG. 28F is a schematic cross-sectional structural diagram after this step is performed.

S279 to S2710 are the same as S257 to S248. For brevity, details are not described herein again.

A structure of the power semiconductor device formed by using the example is shown in FIG. 18 to FIG. 20.

The foregoing are specific implementations of two optional examples of the power semiconductor device provided in Embodiment 2 of this application.

It should be noted that, in the specific implementations of the power semiconductor device and the manufacturing method of the power semiconductor device provided in the foregoing Embodiment 1 and Embodiment 2, an example in which a doping type of a substrate is a P type is used for description. Actually, this embodiment of this application does not limit the doping type of the substrate. As an alternative embodiment of this application, a doping type of the substrate may also be an N type. When the substrate is an N-type substrate, a doping type of the epitaxial layer, the drift region, the first drain electrode, the second drain electrode, the channel, and the body electrode on the substrate also need to be changed correspondingly.

In addition, Embodiment 2 may use a same packaging structure as that used in Embodiment 1. Therefore, a packaging structure of a final device product of the power semiconductor device in Embodiment 2 may also be shown in FIG. 7 and FIG. 8.

The foregoing is a specific implementation of the power semiconductor device and the manufacturing method of the power semiconductor device according to this embodiment of this application.

Based on the semiconductor device provided in the embodiment, as shown in FIG. 34, this application further provides a terminal device 900. The terminal device includes a power semiconductor device 901 and a controller 902, where the power semiconductor device 901 is the power semiconductor device 901 according to any one of the foregoing possible implementations, and the controller 902 is configured to control on and/or off of the power semiconductor device 901. The foregoing is a specific implementation of the power semiconductor device according to this embodiment of this application.

## Claims

1. A semiconductor device, comprising:
a substrate;
an epitaxial layer located on one side of the substrate;
a groove located in the epitaxial layer, wherein
a gate electrode is disposed in the groove, and there is an oxidized layer between an inner wall of the groove and an outer wall of the gate electrode;
drift regions located on two sides of the groove;
a first drain electrode and a second drain electrode that are respectively located in the drift regions on the two sides of the groove; and
a channel, wherein the channel is located between a bottom wall of the groove and the substrate, and is close to a groove bottom of the groove;
a doping type of the substrate, the epitaxial layer, and the channel is a first type, and a doping type of the drift region, the first drain electrode, and the second drain electrode is a second type; and
in the first type and the second type, one is a P type and the other is an N type.

2. The device according to claim 1, wherein
there is a first oxidized layer between an inner side wall of the groove and an outer side wall of the gate electrode, there is a second oxidized layer between the groove bottom of the groove and a bottom of the gate electrode, and the bottom of the gate electrode faces the groove bottom of the groove, wherein the second oxidized layer is a gate oxidized layer; and
the first oxidized layer is a field oxidized layer or a gate oxidized layer, or the first oxidized layer includes both a field oxidized layer and a gate oxidized layer.

3. The device according to claim 1 or 2, wherein along a depth direction of the groove, the groove comprises a main part and a protruding part that extends from the main part and protrudes towards the substrate.

4. The device according to claim 3, wherein one gate electrode is disposed in the groove, and the gate electrode comprises a first part located at the protruding part and a second part located at the main part; the first oxidized layer between an outer side wall of the first part and an inner side wall of the protruding part is the gate oxidized layer, and the first oxidized layer between an outer side wall of the second part and an inner side wall of the main part is the field oxidized layer.

5. The device according to claim 4, wherein a width of the first part is greater than a width of the second part.

6. The device according to claim 3, wherein two gate electrodes that are electrically connected to each other are disposed in the groove; one gate electrode is an upper gate electrode, and the other gate electrode is a lower gate electrode; the upper gate electrode is located at the main part, and the lower gate electrode is located at the protruding part; and the first oxidized layer between an outer side wall of the lower gate electrode and an inner side wall of the protruding part is the gate oxidized layer, and the first oxidized layer between an outer side wall of the upper gate electrode and an inner side wall of the main part is the field oxidized layer.

7. The device according to claim 6, wherein in the groove, a corresponding area obtained by extending an area between the upper gate electrode and the lower gate electrode along a width direction of the groove is a holding area, and there is an insulation layer in the holding area, and the width direction of the groove is perpendicular to the depth direction of the groove.

8. The device according to any one of claims 1 to 3, wherein a plurality of gate electrodes are disposed in the groove, the plurality of gate electrodes are electrically connected, and the plurality of gate electrodes are arranged along the depth direction of the groove; there is the second oxidized layer between the groove bottom of the groove and a bottom of a gate electrode that is closest to the groove bottom of the groove in the plurality of gate electrodes; and the first oxidized layer between the inner side wall of the groove and an outer side wall of the gate electrode that is closest to the groove bottom of the groove in the plurality of gate electrodes is the gate oxidized layer; and the first oxidized layer between an outer side wall of each of the other gate electrodes and the inner side wall of the groove is the field oxidized layer.

9. The device according to claim 8, wherein along a direction from the groove bottom of the groove to a groove opening of the groove, widths of the plurality of gate electrodes are in descending order, and a direction of the widths is perpendicular to the depth direction of the groove.

10. The device according to claim 8 or 9, wherein in the groove, there is an insulation layer in a corresponding area obtained by extending an area between two gate electrodes along the width direction of the groove, and the width direction of the groove is perpendicular to the depth direction of the groove.

11. The device according to any one of claims 1 to 10, wherein the device further comprises a body electrode, the body electrode is located in the epitaxial layer and is close to an outer surface of the epitaxial layer, and at least one cell is located in an area enclosed by the body electrode.

12. The device according to any one of claims 1 to 10, wherein the device further comprises a body electrode and a well region of an isolated island shape located in the groove, and the body electrode is located in the well region and close to an outer surface of the well region; and a doping type of the well region is the first type.

13. The device according to any one of claims 1 to 12, wherein electrodes of the gate electrode, the first drain electrode, and the second drain electrode are all led out to an outer surface of the device.

14. The device according to any one of claims 1 to 13, wherein the first drain electrode and the second drain electrode are symmetrically distributed on the two sides of the groove.

15. A terminal device, comprising a semiconductor device and a controller, wherein the semiconductor device is the semiconductor device according to any one of claims 1 to 14, and the controller is configured to control on and/or off of the semiconductor device.
